# EUROPÄISCHE PATENTSCHRIFT

(11) **EP 2 356 182 B1**
(45) Veröffentlichungstag und Bekanntmachung des Hinweises auf die Patenterteilung: **06.05.2015**
(21) Anmeldenummer: 09753087.7
(22) Anmeldetag: 11.11.2009
(51) Int. Cl.: C09D 4/00, C08F 2/50, G03F 7/00

(54) **STRAHLUNGSHÄRTBARE BESCHICHTUNGSMASSEN**
RADIATION CURABLE COATING MATERIALS
MATIÈRES DE REVÊTEMENT DURCISSABLES PAR RAYONNEMENT

(30) Priorität: 12.11.2008 EP 08168882; 11.02.2009 EP 09152593
(43) Veröffentlichungstag der Anmeldung: 17.08.2011
(73) Patentinhaber: BASF SE, 67056 Ludwigshafen (DE)
(72) Erfinder: HAREMZA, Sylke, 69151 Neckargemünd (DE); BÜSCHEL, Michael, 67549 Worms (DE); KORN, Tobias Johannes, 67227 Frankenthal (DE); BECK, Erich, 68526 Ladenburg (DE); NORD, Simon, 76189 Karlsruhe (DE)
(86) Internationale Anmeldenummer: PCT/EP2009/064967
(87) Internationale Veröffentlichungsnummer: WO 2010/055050

(56) Entgegenhaltungen:
- EP-A1- 1 069 163
- WO-A1-2007/138095
- US-A- 4 048 151
- US-A- 4 956 254
- US-A1- 2007 172 778

## Beschreibung

Die vorliegende Erfindung betrifft strahlungshärtbare Beschichtungsmassen mit neuen Photoinitiatoren und deren Verwendung.

Als Photoinitiatoren werden erfindungsgemäß zweikomponentige IR-Photoinitiatorsysteme eingesetzt, welche mindestens einen Sensibilisatorfarbstoff, auch Sensibilisator genannt, und mindestens einen Radikalinitiator, auch Co-Initiator genannt, enthalten.

Als Sensibilisatorfarbstoff werden im Stand der Technik häufig Farbstoffe, insbesondere Cyanin-, Xanthylium- oder Thiazinfarbstoffe eingesetzt und als Co-Initiatoren beispielsweise Boranatsalze, Sulfoniumsalze, lodoniumsalze, Sulfone, Peroxide, Pyridin-N-oxide oder Halogenmethyltriazine.

Cyaninfarbstoffe bestehen aus einem Cyanin-Kation und einem entsprechenden Anion. Hierbei kann es sich um ein separat vorliegendes Anion handeln, oder aber auch um ein inneres Anion, d.h. dass die anionische Gruppe chemisch mit dem Cyanin-Kation verbunden ist. Üblicherweise fallen sie bei Ihrer Herstellung als einfache Salze, beispielsweise als Halogenide, Tetrafluoroborate, Perchlorate oder Tosylate an. Cyaninfarbstoffe mit Anionen, welche langkettige Alkyl- oder alkylsubstituierte Arylgruppen aufweisen, sind bislang nicht bekannt. Cyaninfarbstoffe sind kommerziell erhältlich.

Kationische Cyaninfarbstoffe werden häufig in Form ihrer Alkyl- und Arylsulfonate, Sulfate, Chloride, Iodide oder dergleichen eingesetzt.

Bei den Sensibilisatoren gemäß der vorliegenden Erfindung handelt es sich um ausgewählte styrylische Cyaninkationen mit ausgewählten Anionen.

Styrylische Cyaninkationen sind beispielsweise bekannt aus US 6110987. Als Anionen für die dort offenbarten styrylischen Cyaninkationen, beispielsweise Strukturen 2, 5, 10, 11, 12 und 13, werden Halogenide und als Sulfonate lediglich Benzolsulfonat, para-Toluolsulfonat und Methylsulfonat beschrieben. Diese weisen mit den Sensibilisatoren nur eine geringe Löslichkeit in Beschichtungsmassen auf.

Das gleiche gilt für die styrylischen Cyaninkationen der EP 915136 B1, der EP 1069163 A1 und der EP 1002817 B1, dort jeweils Strukturen 1, 3, 4, und 6 bis 9, die als Salze von Halogeniden, Perchlorat oder Tetraphenylborat aufgeführt sind. Naphthalinsulfonat als Anion wird als Gegenion für andere Sensibilisatoren beschrieben.

Das gleiche gilt für die Sensibilisatoren gemäß EP 879829 B1 (=US 6165686).

EP 1170339 A2 offenbart styrylische Cyaninkationen mit organischen Metallkomplexen mit Azogruppen.

Aus US 4048151 A sind styrylische Cyaninkationen bekannt, die als Gegenion Cl⁻, ZnCl₃⁻, Methylsulfat oder Acetat aufweisen.

V.S. Jolly, P.I. Ittyerah und K.P. Sharme offenbaren in Orient. J. Chem. 17(2), 275 - 278, 2001, styrylische Cyaninkationen in Form ihrer Iodide.

Aus EP 1091247 A2, Absätze [0109] bis [0111] sind langkettige aliphatische Sulfonate als Gegenionen für Cyaninkationen bekannt.

Langkettige Sulfonate als Anionen sind beispielsweise bekannt aus der WO 2006/058731 und WO 2007/138095 A1. Die dort als Cyaninkationen offenbarten Sen-sibilisatoren zeigen jedoch nach Belichtung eine Farbigkeit, die sich insbesondere in Klarlacken störend auswirkt.

Aufgabe der vorliegenden Erfindung war es, Sensibilisatoren für strahlungshärtbare Beschichtungsmassen zur Verfügung zu stellen, die eine gute Durchhärtung bei Belichtung, eine geringe Farbigkeit nach Härtung und eine gute Löslichkeit in strahlungshärtbaren Beschichtungsmassen zeigen.

Die Aufgabe wurde gelöst durch Sensibilisatorsysteme (A) für strahlungshärtbare Beschichtungsmassen aus einem styrylischen Kation D⁺ der Formel (I) 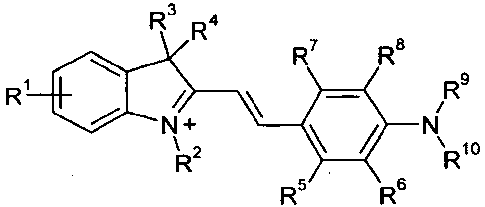 und als Gegenion einem Anion An⁻ ausgewählt aus der Gruppe bestehend aus 4-Hexylbenzolsufonat, 4-Octylbenzolsulfonat, 4-Decylbenzolsulfonat und 4-Dodecylbenzolsulfonat
worin
R¹, R⁵, R⁶, R⁷ und R⁸, jeweils unabhängig voneinander Wasserstoff, C₁ - C₁₈-Alkyl oder C₁ - C₁₈-Alkyloxy,
R¹ zusätzlich Halogen, bevorzugt Brom
R², R³ und R⁴ jeweils unabhängig voneinander C₁ - C₁₈-Alkyl,
R⁹ und R¹⁰ jeweils unabhängig voneinander gegebenenfalls durch Aryl, Alkyl, Aryloxy, Alkyloxy, Heteroatome und/oder Heterocyclen substituiertes C₁ - C₁₈-Alkyl, C₆ - C₁₂-Aryl oder C₅ - C₁₂-Cycloalkyl,
bedeuten können.

Darin bedeuten
gegebenenfalls durch Aryl, Alkyl, Aryloxy, Alkyloxy, Heteroatome und/oder Heterocyclen substituiertes C₁-C₁₈-Alkyl beispielsweise Methyl, Ethyl, Propyl, Isopropyl, n-Butyl, sec-Butyl, tert.-Butyl, Pentyl, Hexyl, Heptyl, Octyl, 2-Etylhexyl, 2,4,4-Trimethylpentyl, Decyl, Dodecyl, Tetradecyl, Heptadecyl, Octadecyl, 1,1-Dimethylpropyl, 1,1-Dimethylbutyl, 1,1,3,3-Tetramethylbutyl, Benzyl, 1-Phenylethyl, 2-Phenylethyl, α,α-Dimethylbenzyl, Benzhydryl, p-Tolylmethyl,1-(p-Butylphenyl)-ethyl, p-Chlorbenzyl, 2,4-Dichlorbenzyl, p-Methoxybenzyl, m-Ethoxybenzyl, 2-Cyanoethyl, 2-Cyanopropyl, 2-Methoxycarbonethyl, 2-Ethoxycarbonylethyl, 2-Butoxycarbonylpropyl, 1,2-Di-(methoxycarbonyl)-ethyl, 2-Methoxyethyl, 2-Ethoxyethyl, 2-Butoxyethyl, Diethoxymethyl, Diethoxyethyl, 1,3-Dioxolan-2-yl, 1,3-Dioxan-2-yl, 2-Methyl-1,3-dioxotan-2-yl, 4-Methyl-1,3-dioxolan-2-yl, 2-Isopropoxyethyl, 2-Butoxypropyl, 2-Octyloxyethyl, Chlormethyl, 2-Chlorethyl, Trichlormethyl, Trifluormethyl, 1,1-Dimethyl-2-chlorethyl, 2-Methoxyisopropyl, 2-Ethoxyethyl, Butylthiomethyl, 2-Dodecylthioethyl, 2-Phenylthioethyl, 2,2,2-Trifluorethyl, 2-Hydroxyethyl, 2-Hydroxypropyl, 3-Hydroxypropyl, 4-Hydroxybutyl, 6-Hydroxyhexyl, 2-Aminoethyl, 2-Aminopropyl, 3-Aminopropyl, 4-Aminobutyl, 6-Aminohexyl, 2-Methylaminoethyl, 2-Methylaminopropyl, 3-Methylaminopropyl, 4-Methylaminobutyl, 6-Methylaminohexyl, 2-Dimethylaminoethyl, 2-Dimethylaminopropyl, 3-Dimethylaminopropyl, 4-Dimethylaminobutyl, 6-Dimethylaminohexyl, 2-Hydroxy-2,2-dimethylethyl, 2-Phenoxyethyl, 2-Phenoxypropyl, 3-Phenoxypropyl, 4-Phenoxybutyl, 6-Phenoxyhexyl, 2-Methoxyethyl, 2-Methoxypropyl, 3-Methoxypropyl, 4-Methoxybutyl, 6-Methoxyhexyl, 2-Ethoxyethyl, 2-Ethoxypropyl, 3-Ethoxypropyl, 4-Ethoxybutyl oder 6-Ethoxyhexyl,
gegebenenfalls durch Aryl, Alkyl, Aryloxy, Alkyloxy, Heteroatome und/oder Heterocyclen substituiertes C₅-C₁₈-Alkyl beispielsweise Pentyl, Hexyl, Heptyl, Octyl, 2-Etylhexyl, 2,4,4-Trimethylpentyl, Decyl, Dodecyl, Tetradecyl, Heptadecyl, Octadecyl, 1,1-Dimethylpropyl, 1,1-Dimethylbutyl, 1,1,3,3-Tetramethylbutyl,
gegebenenfalls durch Aryl, Alkyl, Aryloxy, Alkyloxy, Heteroatome und/oder Heterocyclen substituiertes C₆-C₁₂-Aryl beispielsweise Phenyl, Tolyl, Xylyl, α-Naphthyl, β-Naphthyl, 4-Diphenylyl, Chlorphenyl, Dichlorphenyl, Trichlorphenyl, Difluorphenyl, Methylphenyl, Dimethylphenyl, Trimethylphenyl, Ethylphenyl, Diethylphenyl, iso-Propylphenyl, tert.-Butylphenyl, Dodecylphenyl, Methoxyphenyl, Dimethoxyphenyl, Ethoxyphenyl, Hexyloxyphenyl, Methylnaphthyl, Isopropylnaphthyl, Chlornaphthyl, E-thoxynaphthyl, 2,6-Dimethylphenyl, 2,4,6-Trimethylphenyl, 2,6-Dimethoxyphenyl, 2,6-Dichlorphenyl, 4-Bromphenyl, 2- oder 4-Nitrophenyl, 2,4- oder 2,6-Dinitrophenyl, 4-Dimethylaminophenyl, 4-Acetylphenyl, Methoxyethylphenyl oder Ethoxymethylphenyl,
gegebenenfalls durch Aryl, Alkyl, Aryloxy, Alkyloxy, Heteroatome und/oder Heterocyclen substituiertes C₅-C₁₂-Cycloalkyl beispielsweise Cyclopentyl, Cyclohexyl, Cyclooctyl, Cyclododecyl, Methylcyclopentyl, Dimethylcyclopentyl, Methylcyclohexyl, Dimethylcyclohexyl, Diethylcyclohexyl, Butylcyclohexyl, Methoxycyclohexyl, Dimethoxycyclohexyl, Diethoxycyclohexyl, Butylthiocyclohexyl, Chlorcyclohexyl, Dichlorcyclohexyl, Dichlorcyclopentyl sowie ein gesättigtes oder ungesättigtes bicyclisches System wie z.B. Norbornyl oder Norbornenyl.

Die Reste R¹, R⁵, R⁶, R⁷ und R⁸ sind jeweils unabhängig voneinander bevorzugt Wasserstoff oder C₁- bis C₄-Alkyl, besonders bevorzugt Wasserstoff, Methyl oder Ethyl, ganz besonders bevorzugt Wasserstoff oder Methyl und insbesondere Wasserstoff.

C₁ bis C₄-Alkyl steht in dieser Anmeldung für Methyl, Ethyl, Propyl, Isopropyl, n-Butyl, sec-Butyl oder tert.-Butyl, bevorzugt für Methyl, Ethyl oder n-Butyl, besonders bevorzugt für Methyl oder Ethyl und ganz besonders bevorzugt für Methyl.

Der Rest R¹ befindet sich am Indolring bevorzugt in Position 5 oder 6.

Von den Resten R⁵, R⁶, R⁷ und R⁸ sind bevorzugt mindestens zwei wasserstoff, besonders bevorzugt mindestens 3 und ganz besonders bevorzugt sind alle vier Wasserstoff.

Der Rest R² kann bevorzugt C₁ bis C₄-Alkyl sein, besonders bevorzugt Methyl oder Ethyl und ganz besonders bevorzugt Ethyl.

Die Reste R³ und R⁴ können jeweils unabhängig voneinander bevorzugt Methyl oder Ethyl sein, besonders bevorzugt Ethyl. In einer bevorzugten Ausführungsform sind die beiden Reste R³ und R⁴ gleich.

Bei den Resten R⁹ und R¹⁰ handelt es sich jeweils unabhängig voneinander bevorzugt um gegebenenfalls durch Aryl, Alkyl, Aryloxy, Alkyloxy, Heteroatome und/oder Heterocyclen substituiertes C₁ - C₁₈-Alkyl und besonders bevorzugt um Methyl, Ethyl, n-Propyl, 2-Hydroxyethyl, 2-Hydroxypropyl, 2-Chlorethyl, 2-Cyanethyl, 2-Acetoxyethyl, Cyclohexyl oder Cyclopentyl sein, ganz besonders bevorzugt Methyl, Ethyl, 2-Hydroxyethyl, 2-Chlorethyl und 2-Cyanethyl, insbesondere um Methyl, Ethyl und 2-Cyanethyl.

In einer möglichen Ausführungsform können die Reste R⁹ und R¹⁰ eine gemeinsame Kette bilden, beispielsweise 1,5-Pentylen, 1,4-Butylen oder 3-Oxa-1,5-pentylen.

In einer weiteren möglichen Ausführungsform können die Reste R⁹ und R⁸ bzw. R⁶ und R¹⁰ eine gemeinsame Kette bilden, beispielsweise 1,2-Ethylen 1,3-Propylen. In diesem Fall bilden bevorzugt sowohl die Reste R⁹ und R⁸ als auch R⁶ und R¹⁰ eine Kette, besonders bevorzugt jeweils der gleichen Kettenlänge.

Der Rest R¹¹ ist beispielsweise eine lineare oder verzweigte, bevorzugt eine lineare Alkylgruppe. Bevorzugt handelt es sich um 1-Pentyl, 1-Hexyl-, 2-Ethyl-1-hexyl-, 1-Octyl-, 1-Nonyl, 1-Decyl, 1-Undecyl, 1-Dodecyl- oder 1-Tetradecyl-. Besonders bevorzugt handelt es sich um 1-Hexyl-, 1-Octyl-, 1-Decyl, 1-Dodecyl- oder 1-Tetradecyl-.

Der Rest R¹² kann beispielsweise Methyl, Ethyl, n-Butyl, n-Hexyl, n-Octyl, n-Decyl oder n-Dodecyl, bevorzugt Methyl, Ethyl, n-Butyl, oder n-Dodecyl und besonders bevorzugt Methyl, Ethyl oder n-Dodecyl sein.

Bevorzugt ist das styrylische Cyaninkation D⁺ ausgewählt aus der Gruppe bestehend aus den folgenden Individuen:

| Nr. | R¹ | R² | R³ | R⁴ | R⁵ | R⁶ | R⁷ | R⁸ | R⁹ | R¹⁰ |
|---|---|---|---|---|---|---|---|---|---|---|
| 1 | H | Ethyl | Methyl | Methyl | H | H | H | H | R⁹ + R¹⁰: 1,4-Butylen | |
| 2 | H | Ethyl | Methyl | Methyl | H | * | H | * | * | * |
| 3 | H | Ethyl | Methyl | Methyl | H | H | H | H | 2-Chlorethyl | 2-Chlorethyl |
| 4 | H | Ethyl | Methyl | Methyl | H | H | H | H | 2-Hydroxyethyl | Methyl |
| 5 | H | Ethyl | Methyl | Methyl | H | H | H | H | 2-Hydroxyethyl | 2-Hydroxyethyl |
| 6 | H | Ethyl | Methyl | Methyl | H | H | H | H | 2-Hydroxyethyl | Cyclohexyl |
| 7 | H | Ethyl | Methyl | Methyl | H | H | H | H | 2-Hydroxyethyl | 2-Cyanethyl |
| 8 | H | Ethyl | Methyl | Methyl | H | H | H | H | 2-Acetoxyethyl | 2-Acetoxyethyl |
| 9 | H | Ethyl | Methyl | Methyl | H | H | H | H | 2-Cyanethyl | Methyl |
| 10 | H | Ethyl | Methyl | Methyl | Methyl | H | H | H | 2-Hydroxyethyl | 2-Cyanethyl |
| 11 | H | Ethyl | Methyl | Methyl | Methyl | H | H | H | Ethyl | Ethyl |
| 12 | H | Ethyl | Methyl | Methyl | Methyl | H | H | H | Methyl | Methyl |
| 13 | H | Ethyl | Methyl | Methyl | Methyl | H | H | H | R⁹ + R¹⁰: 1,5-Pentylen | |
| 14 | H | Ethyl | Methyl | Methyl | Methyl | H | H | H | R⁹ + R¹⁰: 3-Oxa1,5-pentylen | |
| 15 | H | Ethyl | Methyl | Methyl | H | H | H | H | R⁹ + R¹⁰: 3-Oxa1,5-pentylen | |
| 16 | H | Ethyl | Methyl | Methyl | H | H | H | H | Methyl | Methyl |
| 17 | H | Methyl | Methyl | Methyl | H | H | H | H | Methyl | 2-Chlorethyl |
| 18 | H | Methyl | Methyl | Methyl | Methyl | H | H | H | Ethyl | 2-Chlorethyl |
| 19 | H | Ethyl | Methyl | Methyl | H | H | H | H | 2-Cyanethyl | 2-Cyanethyl |
| 20 | H | Methyl | Methyl | Methyl | H | H | H | H | 2-Cyanethyl | 2-Cyanethyl |

| | | | | | | | | | | |
|---|---|---|---|---|---|---|---|---|---|---|
| * Nr..2; R⁹ + R⁸: 1,3-Propylen, R¹⁰ + R⁶: 1,3-Propylen | | | | | | | | | | |

Es handelt sich bei dem Anion An- um 4-Hexylbenzolsulfonat, 4-Octylbenzolsulfonat, 4-Decylbenzolsulfonat oder 4-Dodecylbenzolsulfonat. Insbesondere bevorzugt ist 4-n-Dodecylbenzolsulfonat als An-.

Der Sensibilisator wird bevorzugt im Gemisch mit einem Co-Initiator (B) eingesetzt der Formel (IV), 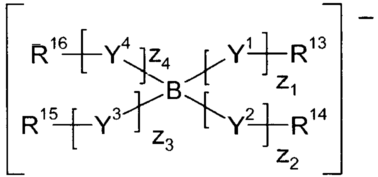 mit einem assoziierten Gegenion ¹/ₓ Kat^{x+},
worin
x 1 oder 2,
Kat ein Kation,
Z¹, Z², Z³ und Z⁴ unabhängig voneinander jeweils 0 oder 1, wobei die Summe Z¹+ Z² + Z³ + Z⁴ 0, 1, 2 oder 3, bevorzugt 0,1 oder 2, besonders bevorzugt 0 oder 1 und ganz besonders bevorzugt 0 ist,
Y¹, Y², Y³ und Y⁴ unabhängig voneinander jeweils O, S oder NR¹⁷,
R¹³, R¹⁴, R¹⁵ und R¹⁶ jeweils unabhängig voneinander C₁ - C₁₈-Alkyl, gegebenenfalls durch ein oder mehrere Sauerstoff- und/oder Schwefelatome und/oder ein oder mehrere substituierte oder unsubstituierte Iminogruppen unterbrochenes C₂ - C₁₈-Alkyl, C₆-C₁₂-Aryl, C₅ - C₁₂-Cycloalkyl oder einen fünf- bis sechsgliedrigen, Sauerstoff-, Stickstoff- und/oder Schwefelatome aufweisenden Heterocyclus, wobei die genannten Reste jeweils durch Aryl, Alkyl, Aryloxy, Alkyloxy, Heteroatome und/oder Heterocyclen substituiert sein können, und
R¹⁷ Wasserstoff, C₁ - C₁₈-Alkyl oder C₆-C₁₂-Aryl
bedeuten,
mit der Maßgabe, dass mindestens einer der Reste R¹³ bis R¹⁶ ein C₁ - C₁₈-Alkylrest ist und mindestens einer der Reste R¹³ bis R¹⁶ ein C₆-C₁₂-Arylrest, wobei die genannten Reste jeweils durch Aryl, Alkyl, Aryloxy, Alkyloxy, Heteroatome und/oder Heterocyclen substituiert sein können.

Y¹, Y², Y³ und Y⁴ sind unabhängig voneinander bevorzugt Sauerstoff oder NR¹⁷ und besonders bevorzugt Sauerstoff.

R¹⁷ ist bevorzugt Wasserstoff oder C₁ - C₄-Alkyl.

R¹³, R¹⁴, R¹⁵ und R¹⁶ sind bevorzugt jeweils unabhängig voneinander C₁ - C₁₈-Alkyl, C₆-C₁₂-Aryl oder C₅-C₁₂-Cycloalkyl, bevorzugt bevorzugt C₁-C₁₈-Alkyl und C₆-C₁₂-Aryl, ganz besonders bevorzugt ausgewählt aus der Gruppe bestehend aus Methyl, Ethyl, Propyl, Isopropyl, n-Butyl, sec-Butyl, tert.-Butyl, Pentyl, Hexyl, Heptyl, Octyl, 2-Ethylhexyl, 2,4,4-Trimethylpentyl, Decyl, Dodecyl, Tetradecyl, Heptadecyl, Octadecyl, 1,1-Dimethylpropyl, 1,1-Dimethylbutyl, 1,1,3,3-Tetramethylbutyl, Benzyl, 1-Phenylethyl, 2-Phenylethyl, α,α-Dimethylbenzyl, Benzhydryl, p-Tolylmethyl,1-(p-Butylphenyl)-ethyl, Phenyl, Tolyl, Xylyl, α-Naphthyl, β-Naphthyl, 4-Diphenylyl, Methylphenyl, Dimethylphenyl, Trimethylphenyl, Ethylphenyl, Diethylphenyl, iso-Propylphenyl, tert.-Butylphenyl und Dodecylphenyl, insbesondere ausgewählt aus der Gruppe bestehend aus Methyl, Ethyl, Propyl, n-Butyl, Hexyl, Octyl, 2-Ethylhexyl, Dodecyl, Benzyl, 2-Phenylethyl, Phenyl, Tolyl, α-Naphthyl und β-Naphthyl und speziell ausgewählt aus der Gruppe bestehend aus Methyl, Ethyl, n-Propyl, n-Butyl, Benzyl, Phenyl und Tolyl.

Erfindungsgemäß ist von den Resten R¹³ bis R¹⁶ mindestens einer C₁ - C₁₈-Alkyl und mindestens einer C₆-C₁₂-Aryl, bevorzugt sind mindestens einer C₁-C₁₈-Alkyl und mindestens einer C₆-C₁₂-Aryl und die beiden anderen ebenfalls ausgewählt aus der Gruppe umfassend C₁-C₁₈-Alkyl und C₆-C₁₂-Aryl, besonders bevorzugt sind mindestens einer C₁-C₁₈-Alkyl und mindestens zwei C₆-C₁₂-Aryl und ganz besonders bevorzugt ist einer C₁-C₁₈-Alkyl und drei C₆-C₁₂-Aryl.

Die Menge des in der strahlungshärtbaren Beschichtungsmasse enthaltenen Sensibilisatorfarbstoffs (A) wird vom Fachmann so gewählt, dass eine ausreichende Photohärtung der Beschichtungsmasse erreicht wird. Im Regelfalle ist eine Menge von weniger als 5 Gew. % ausreichend. Insbesondere bewährt hat sich eine Menge von 0,05 bis 4 Gew. % bezüglich der Summe aller Komponenten der Beschichtungsmasse, bevorzugt 0,1 bis 3 Gew. %, besonders bevorzugt 0,2 bis 2,5 Gew. % und ganz besonders bevorzugt 0,3 bis 2,0 Gew. %. Es muss erfindungsgemäß gewährleistet sein, dass zugegebener Sensibilisatorfarbstoff vollständig in der Beschichtungsmasse gelöst ist.

Bevorzugt beträgt die Löslichkeit des Sensibilisatorfarbstoffs in der Beschichtungsmasse mindestens 0,2 Gew. %, besonders bevorzugt mindestens 0,5 Gew. %, ganz besonders bevorzugt mindestens 1,0 Gew. % und beispielsweise mindestens 2 Gew. %.

Erfindungsgemäß enthalten die erfindungsgemäßen Mischungen ebenfalls eine Komponente (B) aus einer anionischen Borverbindung der Formel (IV).

Diese anionischen Borverbindungen besitzen als Gegenion ein x-fach positiv geladenes Kation Kat^{x+}. Dabei kann es sich beispielsweise um (Erd)alkalimetall- oder Ammoniumionen handeln, z.B. Mg²⁺, Li⁺, Na⁺ oder K⁺, bevorzugt handelt es sich jedoch um Ammoniumionen.

Ammoniumionen im Sinne der vorliegenden Erfindung sind ionische Verbindungen, die mindestens ein vierfach substituiertes Stickstoffatom enthalten, wobei die Substituenten ausgewählt sind aus C₁-C₁₈-Alkyl und C₆-C₁₂-Aryl, bevorzugt handelt es sich um Alkylreste. Selbstverständlich können auch zwei oder mehr Substituenten zu einem Ring verknüpft sein, so dass das quaternäre Stickstoffatom Teil eines fünf- bis siebengliedrigen Ringes ist.

Beispiele für Ammonium-Kationen sind Tetra-n-octylammonium, Tetramethylammonium, Tetraethylammonium, Tetra-n-butylammonium, Trimethylbenzylammonium, Trimethylcetylammonium, Triethylbenzylammonium, Tri-n-butylbenzylammonium, Trimethylethylammonium, Tri-n-butylethylammonium, Triethylmethylammonium, Tri-n-butylmethylammonium, Di-isopropyl-diethylammonium, Di-isopropyl-ethylmethylammonium, Di-isopropyl-ethyl-benzylammonium, N,N-Dimethylpiperidinium, N,N-Dimethylmorpholinium, N,N-Dimethylpiperazinium oder N-Methyldiazabicyclo[2,2,2]octan. Bevorzugte Alkylammoniumionen sind Tetraoctylammonium, Tetramethylammonium, Tetraethylammonium und Tetra-n-butylammonium, besonders bevorzugt sind Tetraoctylammonium und Tetra-n-butylammonium und ganz besonders bevorzugt ist Tetra-n-butylammonium.

Ringsysteme enthaltende Ammoniumionen sind beispielsweise methylierte, ethylierte, n-butylierte, cetylierte oder benzylierte Piperazine, Piperidine, Imidazole, Morpholine, Chinuclidine, Chinoline, Pyridine oder Triethylendiamine.

In einer bevorzugten Ausführungsform handelt es sich bei den Kationen Kat^{x+} der anionischen Borverbindung um solche Kationen, wie sie beschrieben sind in WO 2008/058885 A2, Seite 16, Zeile 30 bis Seite 25, Zeile 29. Diese Textstellen sei hiermit Bestandteil der vorliegenden Offenbarung.

Besonders bevorzugt sind solche Kationen Kat^{x+} ausgewählt aus der Gruppe bestehend aus 1-Methylimidazolium, 1-Butylimidazolium, 1,3-Dimethylimidazolium, 1,2,3-Trimethylimidazolium, 1-n-Butyl-3-methylimidazolium, 1-Ethyl-3-methylimidazolium, 1,3,4,5-Tetramethylimidazolium, 1,3,4-Trimethylimidazolium, 2,3-Dimethylimidazolium, 1-Butyl-2,3-dimethylimidazolium, 3,4-Dimethylimidazolium, 2-Ethyl-3,4-dimethylimidazolium, 3-Methyl-2-ethylimidazol, 3-Butyl-1-methylimidazolium, 3-Ethyl-1-methylimidazolium, 3-Butyl-1-ethylimidazolium, 3-Butyl-1,2-dimethylimidazolium, 1,3-Di-n-Butylimidazolium, 3-Butyl-1,4,5-Trimethylimidazolium, 3-Butyl-1,4-Dimethylimidazolium, 3-Butyl-2-methylimidazolium, 1,3-Dibutyl-2-methylimidazolium, 3-Butyl-4-methylimidazolium, 3-Butyl-2-ethyl-4-methylimidazolium und 3-Butyl-2-ethylimidazolium, 1-Methyl-3-Octylimidazolium, 1-Decyl-3-Methylimidazolium.

Insbesondere bevorzugt sind als Kat^{x+} 1-Methylimidazolium, 1-Butylimidazolium, 1-Butyl-4-methylpyridinium, 1-n-Butyl-3-methylimidazolium, 1-Ethyl-3-methylimidazolium und 1-n-Butyl-3-ethylimidazolium.

Ein weiterer Gegenstand der vorliegenden Erfindung sind als Photoinitiatoren verwendbare Mischungen der Komponenten (A) und (B):
Die erfindungsgemäßen Mischungen enthalten
   - mindestens eine Komponente (A) der Formel An- Cya⁺, wie oben angegeben, und
   - mindestens eine Komponente (B), bevorzugt der Formel (IV), mit einem Gegenion ¹/ₓ Kat^{x+}.

Die erfindungsgemäßen Mischungen können zusätzlich auch Sulfoniumsalze, lodoniumsalze, Sulfone, Peroxide, Pyridin-N-oxide oder Halogenmethyltriazine als Sensibilisatorfarbstoff enthalten.

Geeignete Sulfoniumsalze sind beispielsweise beschrieben in DE-A1 197 30 498, dort besonders auf Seite 3, Zeile 28 - 39.

Dabei handelt es sich bevorzugt um solche der Formel 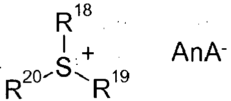 worin
R¹⁸ und R¹⁹ jeweils eine gegebenenfalls substituierte Arylgruppe bedeuten,und
R²⁰ eine gegebenenfalls substituierte Alkylgruppe, eine gegebenenfalls substituierte Alkenylgruppe, eine gegebenenfalls substituierte alicyclische Gruppe, eine gegebenenfalls substituierte Arylgruppe oder eine gegebenenfalls substituierte Aralkylgruppe bedeutet und AnA⁻ ein Anion bedeutet.

Besonders bevorzugt sind Triphenylsulfonium, Diphenylanisylsulfonium, Diphenyl-(4-tolyl)-sulfonium, Diphenyl-(4-fluorphenyl)-sulfonium, Diphenyl-[4-(phenylthio)-phenyl)-sulfonium, Diphenylbenzylsulfonium, Diphenyl-(4-chlorbenzyl)-sulfonium, Diphenyl-(4-brombenzyl)sulfonium, Diphenyl-(4-cyanobenzyl)-sulfonium, Di-(4-tertbutylphenyl)-benzylsulfonium, Dianisyl(4-bromphenylsulfonium, Diphenylphenacylsulfonium, Diphenyl-(4-chlorphenacyl)sulfonium, Diphenyl-(4-cyanophenacyl)-sulfonium, Diphenylallylsulfonium, Diphenylmesylsulfonium, Diphenyl-p-toluolsulfonylmethylsulfonium, Diphenyl-(dimethylsulfoniumylmethyl)-sulfonium und Diphenyl-[4-(diphenylsulfoniumyl)-phenyl]-sulfonium.

Bevorzugte Anionen AnA- sind BF₄⁻, PF₆⁻, AsF₆⁻, SbF₆⁻, ClO₄⁻, Cl⁻, Br, Tetraphenylborat, Tetrakis-(pentafluorphenyl)-borat, das Benzolsulfonatanion, das p-Toluolsulfonatanion und das Trifluormethansulfonatanion.

Geeignete lodoniumsalze sind beispielsweise beschrieben in DE-A1 197 30 498, dort besonders auf Seite 3, Zeile 40 - 43.

Dabei handelt es sich bevorzugt um solche der Formel

R²¹ - I⁺ - R²² AnB⁻

worin
R²¹ und R²² gegebenenfalls substituierte Arylgruppen bedeuten und AnB⁻ ein Anion bedeutet.

Besonders bevorzugt sind Diphenyliodonium, Anisylphenyliodonium, Di-(4-tert-butylphenyl)-iodonium, Di-(4-chlorphenyl)-iodonium, Di-tolyliodonium und Di-(3-nitrophenyl)-iodonium.

Bevorzugte Anionen AnB⁻ sind BF₄⁻, PF₆⁻, AsF₆⁻, SbF₆⁻, ClO₄⁻, Cl⁻, Br, Tetraphenylborat, Tetrakis-(pentafluorphenyl)-borat, das Benzolsulfonatanion, das p-Toluolsulfonatanion und das Trifluormethansulfonatanion.

Geeignete Sulfone sind beispielsweise beschrieben in DE-A1 197 30 498, dort besonders auf Seite 4, Zeile 1 - 12.

Dabei handelt es sich bevorzugt um solche der Formel 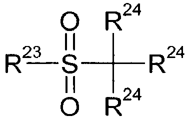 worin
R²³ eine gegebenenfalls substituierte Arylgruppe bedeutet und die Reste R²⁴ jeweils ein Halogenatom bedeuten.

Halogen umfasst im Rahmen dieser Schrift Fluor, Chlor, Brom und Iod, bevorzugt Chlor und Brom und besonders bevorzugt Chlor.

Besonders bevorzugt sind Trichlormethylphenylsulfon, Tribrommethylphenylsulfon, Trichlormethyl-4-chlorphenylsulfon, Tribrommethyl-4-nitrophenylsulfon, 2-Trichlormethylbenzothiazolsulfon, 2,4-Dichlorphenyltrichlormethylsulfon, 2-Methyl-4-chlorphenyltrichlormethylsulfon und 2,4-Dichlorphenyltribrommethylsulfon.

Geeignete Peroxide sind beispielsweise beschrieben in DE-A1 197 30 498, dort besonders auf Seite 4, Zeile 13 - 24.

Dabei handelt es sich bevorzugt um solche der Formel 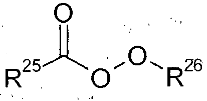 worin
R²⁵ eine gegebenenfalls substituierte Arylgruppe bedeutet und
R²⁶ eine gegebenenfalls substituierte Alkylgruppe, eine gegebenenfalls substituierte Arylgruppe oder eine gegebenenfalls substituierte Benzoylgruppe, bevorzugt der Formel R²⁵-(CO)- bedeutet.

Besonders bevorzugt sind Benzoylperoxid, 2,4-Dichiorbenzoylperoxid, tert-Butylperoxybenzoat, Di-(tert-butylperoxy)-isophthalat, Di-(tert.-butylperoxy)-terephthalat, Di-(tert-butylperoxy)-phthalat, 2,5-Dimethyl-di-(benzoylperoxy)-hexan und 3,3',4,4'-Tetra-(tert- butylperoxycarbonyl)-benzophenon.

Geeignete Pyridin-N-oxide sind beispielsweise beschrieben in DE-A1 197 30 498, dort besonders auf Seite 3, Zeile 44 - 62.

Dabei handelt es sich bevorzugt um solche der Formel 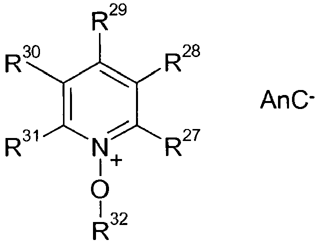 worin
R²⁷, R²⁸, R²⁹, R³⁰ oder R³¹ jeweils unabhängig voneinander ein Wasserstoffatom, ein Halogenatom, eine Cyanogruppe, eine gegebenenfalls substituierte Alkylgruppe, eine gegebenenfalls substituierte Alkoxygruppe oder eine gegebenenfalls substituierte Arylgruppe, R³² eine gegebenenfalls substituierte Alkylgruppe und AnC⁻ ein Anion bedeuten.

Besonders bevorzugt sind N-Methoxypyridinium, N-Ethoxypyridinium, N-Methoxy-2-picolinium, N-Methoxy-3-picolinium, N-Ethoxy-2-picolinium, N-Ethoxy-3-picolinium, N-Methoxy-4-brompyridinium, N-Methoxy-3-brompyridinium, N-Methoxy-2-brompyridinium, N-Ethoxy-4-brompyridinium, N-Ethoxy-3-brompyridinium, N-Ethoxy-2-brompyridinium, N-Ethoxy-4-chlorpyridinium, N-Ethoxy-3-chlorpyridinium, N-Ethoxy-2-chlorpyridinium, N-Methoxy-4-methoxypyridinium, N-Methoxy-3-methoxypyridinium, N-Methoxy-2-methoxypyridinium, N-Ethoxy-4-methoxypyridinium, N-Ethoxy-3-methoxypyridinium, N-Ethoxy-2-methoxypyridinum, N-Methoxy-4-phenylpyridinium, N-Methoxy-3-phenylpyridinium, N-Methoxy-2-phenylpyridinium, N-Ethoxy-4-phenylpyridinium, N-Ethoxy-3-phenyl-pyridinium, N-Ethoxy-2-phenylpyridinium, N-Methoxy-4-cyanopyridinium-, N-Ethoxy-4-cyanopyridinium, N,N'-Dimethoxy-4,4'-bipyridinium, N,N'-Diethoxy-4,4'-bipyridinium, N,N'-Dimethoxy-2,2'-bipyridinium und N,N'-Diethoxy-2,2'-bipyridinium.

Bevorzugte Anionen AnC⁻ sind BF₄⁻, PF₆⁻, AsF₆⁻, SbF₆⁻, ClO₄⁻, Cl⁻, Br, Tetraphenylborat, Tetrakis-(pentafluorphenyl)-borat, das Benzolsulfonatanion, das p-Toluolsulfonatanion und das Trifluormethansulfonatanion.

Geeignete Halogenmethyltriazine sind beispielsweise beschrieben in DE-A1 197 30 498, dort besonders auf Seite 4, Zeile 25 - 40.

Dabei handelt es sich bevorzugt um solche der Formel 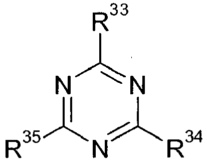 worin
R³³, R³⁴ und R³⁵ jeweils unabhängig voneinander eine Trihalogenmethylgruppe, eine gegebenenfalls substituierte Alkylgruppe, eine gegebenenfalls substituierte Alkenylgruppe oder eine gegebenenfalls substituierte Arylgruppe bedeuten, mit der Maßgabe, dass es sich bei mindestens einer der Gruppen um eine Trihalogenmethylgruppe handelt.

Besonders bevorzugt sind 2,4,6-Tris(trichlormethyl)-s-triazin, 2,4,6-Tris-(tribrommethyl)s-triazin, 2,4-Bis-(dichlormethyl)-6-trichlormethyl-s-triazin, 2-Propionyl-4,6-bis-(trichlormethyl)-s-triazin, 2-Benzoyl-4,6-bis-(trichlormethyl)-s-triazin, 2-(4-Cyanophenyl-4,6-bis-(trichlormethyl)-s-triazin, 2-(4-Nitrophenyl)-4,6-bis-(trichlormethyl)-s-triazin, 2-(4-Chlorphenyl-4,6-bis-(trichlormethyl)-s-triazin, 2-(4-Cumenyl)-4,6-bis-(trichlormethyl)-s-triazin, 2-(4-Aminophenyl)-4,6-bis-(trichlormethyl)-s-triazin, 2,4-Bis-(4-methoxyphenyl)-6-trichlormethyl, 2,4-Bis-(3-chlorphenyl)-6-trichlormethyl-s-triazin, 2-(4-Methoxystyryl-(trichlormethyl)-s-triazin, 2-(4-Chlorstyryl)-4,6-bis-(trichlormethyl)-s-triazin, 2-(4-Aminophenyl)-4,6-bis-(trichlormethyl)-s-triazin, 2,4-Bis-(4-methoxyphenyl)-6-trichlormethyl-s-triazin, 2,4-Bis-(3-chlorphenyl)-6-trichlormethyl-s-triazin, 2-(4-methoxystyryl)-4,6-bis-(trichlormethyl)-s-triazin, 2-(4-Chlorstyryl)-4,6-bis-(trichlormethyl)-s-triazin, 2-(4-Aminostyryl)-4,6-bis-(dichlormethyl)-s-triazin, 2-(4'-Methoxy-1'-naphthyl)-4,6-bis-(trichlormethyl)-s-triazin und 2-(6'-Nitro- 1'-naphthyl)-4,6-bis-(trichlormethyl)-s-triazin.

Des weiteren kann die Mischung noch mindestens ein Lösungsmittel (C) enthalten. Dies können beispielsweise Ester, wie z.B. Butylacetat oder Ethylacetat, aromatische oder (cyclo)aliphatische Kohlenwasserstoffe, wie z.B. Xylol, Toluol oder Heptan, Ketone, wie z.B. Aceton, iso-Butylmethylketon, Methylethylketon oder Cyclohexanon, Alkohole wie z.B. Ethanol, Isopropanol, Mono- oder niedere Oligoethylen- oder -propylenglykole, ein- oder zweifach veretherte Ethylen- oder Propylenglykolether, Glykoletheracetate, wie z.B. Methoxypropylacetat, cyclische Ether wie Tetrahydrofuran, Carbonsäureamide wie Dimethylformamid oder N-Methylpyrrolidon und/oder Wasser sein.

Bevorzugte erfindungsgemäße Mischungen bestehen aus
- mindestens einer Komponente (A) der Formel An⁻ Cya⁺ wie oben angegeben,
- mindestens einer Komponente (B), bevorzugt der Formel (IV), mit einem Gegenion ¹/ₓ Kat^{x+}, und
- gegebenenfalls mindestens ein Lösungsmittel (C).

In einer bevorzugten Ausführungsform werden die erfindungsgemäßen Mischungen ohne Lösungsmittel (C) eingesetzt.

Das Gewichtsverhältnis zwischen Komponente (A) der Formel An- Cya⁺ und Komponente (B) der Formel (IV) mit Gegenion ¹/ₓ Kat^{x+} beträgt in den erfindungsgemäßen Mischungen bevorzugt 1 : 1 bis 1 : 5, besonders bevorzugt 1 : 1 bis 1 : 4, ganz besonders bevorzugt 1 : 2 bis 1 : 4.

Die erfindungsgemäßen Mischungen sind in Beschichtungsmassen gut löslich. Die Löslichkeit kann durch die Wahl des Anions und der Substituenten am Kation beeinflusst werden. Längere Alkylketten als Substituenten am Cyanin oder am Anion der Formel (II) oder (III) führen im allgemeinen auch zu besserer Löslichkeit.

Die erfindungsgemäßen Sensibilisatorfarbstoffe weisen in der Regel Absorptionsmaxima im Wellenlängenbereich von 400 nm bis 650 nm auf. Das Absorptionsmaximum des Sensibilisatorfarbstoffes kann vom Fachmann in prinzipiell bekannter Art und Weise durch die Wahl der Substituenten am Cyaninkation beeinflusst werden.

Bei der zur Photohärtung eingesetzten IR-Strahlung kann es sich sowohl um breitbandige Strahlung wie etwa von Leuchtdioden (LED), Halogenlampen, Xe-Lampen etc. handeln. Es kann sich auch um schmalbandige Strahlung handeln oder um Laserstrahlung einer ganz bestimmten Wellenlänge. Als Laser eignen sich insbesondere die bekannten, im IR-Bereich emittierenden Laser, beispielsweise Halbleiterdiodenlaser. Die Strahlung kann kontinuierlich oder gepulst, beispielsweise in Form von Blitzen, zugeführt werden.

Ein weiterer Gegenstand der vorliegenden Erfindung sind strahlungshärtbare Beschichtungsmassen, die die erfindungsgemäßen Mischungen enthalten.

Derartige Beschichtungsmassen enthalten typischerweise
- mindestens eine Komponente (A) der Formel An⁻ Cya⁺, wie oben angegeben,
- mindestens eine Komponente (B), bevorzugt der Formel (IV), mit einem Gegenion ¹/ₓ Kat^{x+},
- gegebenenfalls mindestens ein Lösungsmittel (C),
- mindestens ein Bindemittel (D),
- gegebenenfalls mindestens einen Reaktivverdünner (E),
- gegebenenfalls mindestens einen UV-Photoinitiator (F),
- gegebenenfalls mindestens ein Farbmittel (G) und
- gegebenenfalls weitere lacktypische Additive (H).

Bindemittel (D) sind Verbindungen mit radikalisch polymerisierbaren ethylenisch ungesättigten Gruppen. Vorzugsweise enthält die strahlungshärtbare Masse 0,001 bis 12, besonders bevorzugt 0,1 bis 8 und ganz besonders bevorzugt 0,5 bis 7 Mol, strahlungshärtbare ethylenisch ungesättigte Gruppen auf 1000 g strahlungshärtbare Verbindungen.

Als strahlungshärtbare Verbindungen kommen z. B. (Meth)acrylverbindungen, Vinylamide, ungesättigte Polyester, z.B. auf Basis von Maleinsäure oder Fumarsäure, oder Maleinimid/Vinylether-Systemen in Betracht.

Bevorzugt sind (Meth)acrylatverbindungen wie Polyester(meth)acrylate, Polyether(meth)acrylate, Urethan(meth)acrylate, Epoxy(meth)acrylate, Carbonat(meth)acrylate, Silikon(meth)acrylate, acrylierte Polyacrylate.

Vorzugsweise handelt es sich bei mindestens 40 Mol%, besonders bevorzugt bei mindestens 60 % der strahlungshärtbaren ethylenisch ungesättigten Gruppen um (Meth)acrylgruppen.

Die strahlungshärtbaren Verbindungen können z.B. als Lösung, z.B. in einem organischen Lösungsmittel oder Wasser, als wäßrige Dispersion oder als Pulver vorliegen.

Bevorzugt sind die strahlungshärtbaren Verbindungen und somit auch die strahlungshärtbaren Massen bei Raumtemperatur fließfähig. Es kann aber auch vorteilhaft sein, die strahlungshärtbare Verbindung bzw, die Beschichtungsmasse in Form einer Schmelze oder als Pulver (Pulverlack) zu applizieren. Die strahlungshärtbaren Massen enthalten vorzugsweise weniger als 20 Gew.%, insbesondere weniger als 10 Gew.% organische Lösemittel und/oder Wasser. Bevorzugt sind sie lösungsmittelfrei und was-serfrei (sog. 100 % Systeme). In diesem Fall kann bevorzugt auf einen Trocknungsschritt verzichtet werden.

Reaktivverdünner (E) sind beispielsweise Ester der (Meth)acrylsäure mit Alkoholen, die 1 bis 20 C-Atome aufweisen, z.B. (Meth)acrylsäuremethylester, (Meth)acrylsäureethylester, (Meth)acrylsäurebutylester, (Meth)acrylsäure-2-ethylhexylester, 2-Hydroxyethylacrylat, 4-Hydroxybutylacrylat, Dihydrodicyclopentadienylacrylat, Vinylaromatische Verbindungen, z.B. Styrol, Divinylbenzol, α,β-ungesättigte Nitrile, z.B. Acrylnitril, Methacrylnitril, α,β-ungesättigte Aldehyde, z.B. Acrolein, Methacrolein, Vinylester, z.B. Vinylacetat, Vinylpropionat, halogenierte ethylenisch ungesättigte Verbindungen, z.B. Vinylchlorid, Vinylidenchlorid, konjugierte ungesättigte Verbindungen, z.B. Butadien, Isopren, Chloropren, einfach ungesättigte Verbindungen, z.B. Ethylen, Propylen, 1-Buten, 2-Buten, iso-Buten, cyclische einfach ungesättigte Verbindungen, z.B. Cyclopenten, Cyclohexen, Cyclododecen, N-Vinylformamid, Allylessigsäure, Vinylessigsäure, monoethylenisch ungesättigten Carbonsäuren mit 3 bis 8 C-Atomen sowie deren wasserlöslichen Alkalimetall-, Erdalkalimetall- oder Ammoniumsalze wie beispielsweise: Acrylsäure, Methacrylsäure, Dimethylacrylsäure, Ethacrylsäure, Maleinsäure, Citraconsäure, Methylenmalonsäure, Crotonsäure, Fumarsäure, Mesaconsäure und Itaconsäure, N-Vinylpyrrolidon, N-Vinyllactame, wie z.B. N-Vinylcaprolactam, N-Vinyl-N-Alkyl-carbonsäureamide oder N-Vinyl-carbonsäureamide, wie z.B. N-Vinylacetamid, N-Vinyl-N-methylformamid und N-Vinyl-N-methylacetamid oder Vinylether, z.B. Methylvinylether, Ethylvinylether, n-Propylvinylether, Isopropylvinylether, n-Butylvinylether, sek-Butylvinylether, Isobutylvinylether, tert.-Butylvinylether, 4-Hydroxybutylvinylether, sowie Gemische davon.

(Meth)Acrylsäure steht in dieser Schrift für Methacrylsäure und Acrylsäure, bevorzugt für Acrylsäure.

Als UV-Photoinitiatoren (F) können dem Fachmann bekannte Photoinitiatoren verwendet werden, z.B. solche in "Advances in Polymer Science", Volume 14, Springer Berlin 1974 oder in K. K. Dietliker, Chemistry and Technology of UV- and EB-Formulation for Coatings, Inks and Paints, Volume 3; Photoinitiators for Free Radical and Cationic Polymerization, P. K. T. Oldring (Eds), SITA Technology Ltd, London, genannten. Im Gegensatz zu den IR-Photoinitiatoren werden die UV-Photoinitiatoren im wesentlichen durch Licht im Wellenlängenbereich von λ=200 bis 700 nm angeregt, besonders bevorzugt von A=200 bis 500 nm und ganz besonders bevorzugt λ=250 bis 400 nm.

Erfindungsgemäß werden darunter solche Photoinitiatoren verstanden, die unter Lichteinwirkung Radikale freisetzen und eine radikalische Reaktion, beispielsweise eine radikalische Polymerisation, starten können.

In Betracht kommen beispielsweise Phosphinoxide, Benzophenone, -Hydroxy-alkyl-aryl-ketone, Thioxanthone, Anthrachinone, Acetophenone, Benzoine und Benzoinether, Ketale, Imidazole oder Phenylglyoxylsäuren und Gemische davon.

Phosphinoxide sind beispielsweise Mono- oder Bisacylphosphinoxide, wie sie z.B. in EP-A 7 508, EP-A 57 474, DE-A 196 18 720, EP-A 495 751 oder EP-A 615 980 beschrieben sind, beispielsweise 2,4,6-Trimethylbenzoyldiphenylphosphinoxid, Ethyl-2,4,6-trimethylbenzoylphenylphosphinat oder Bis(2,6-dimethoxybenzoyl)-2,4,4-trimethylpentylphosphinoxid,

Benzophenone sind beispielsweise Benzophenon, 4-Aminobenzophenon, 4,4'-Bis(dimethylamino)benzophenon, 4-Phenylbenzophenon, 4-Chlorbenzophenon, Michlers Keton, o-Methoxybenzophenon, 2,4,6-Trimethylbenzophenon, 4-Methylbenzophenon, 2,4-Dimethylbenzophenon, 4-Isopropylbenzophenon, 2-Chlorbenzophenon, 2,2'-Dichlorbenzophenon, 4-Methoxybenzophenon, 4-Propoxybenzophenon oder 4-Butoxybenzophenon, α-Hydroxy-alkyl-aryl-ketone sind beispielsweise 1-Benzoylcyclohexan-1-ol (1-Hydroxy-cyclohexyl-phenylketon), 2-Hydroxy-2,2-dimethylacetophenon (2-Hydroxy-2-methyl-1-phenyl-propan-1-on), 1-Hydroxyacetophenon, 1-[4-(2-Hydroxyethoxy)-phenyl]-2-hydroxy-2-methyl-1-propan-1-on oder Polymeres, das 2-Hydroxy-2-methyl-1-(4-isopropen-2-yl-phenyl)-propan-1-on einpolymerisiert enthält

Xanthone und Thioxanthone sind beispielsweise 10-Thioxanthenon, Thioxanthen-9-on, Xanthen-9-on, 2,4-Dimethylthioxanthon, 2,4-Diethylthioxanthon, 2,4-Di-isopropylthioxanthon, 2,4-Dichlorthioxanthon oder Chloroxanthenon,

Anthrachinone sind beispielsweise β-Methylanthrachinon, tert-Butylanthrachinon, Anthrachinoncarbonsäureester, Benz[de]anthracen-7-on, Benz[a]anthracen-7,12-dion, 2-Methylanthrachinon, 2-Ethylanthrachinon, 2-tert-Butylanthrachinon, 1-Chloranthrachinon oder 2-Amylanthrachinon,

Acetophenone sind beispielsweise Acetophenon, Acetonaphthochinon, Valerophenon, Hexanophenon, α-Phenylbutyrophenon, p-Morpholinopropiophenon, Dibenzosuberon, 4-Morpholinobenzophenon, p-Diacetylbenzol, 4'-Methoxyacetophenon, α-Tetralon, 9-Acetylphenanthren, 2-Acetylphenanthren, 3-Acetylphenanthren, 3-Acetylindol, 9-Fluorenon, 1-Indanon, 1,3,4-Triacetylbenzol, 1-Acetonaphthon, 2-Acetonaphthon, 2,2-Dimethoxy-2-phenylacetophenon, 2,2-Diethoxy-2-phenylacetophenon, 1,1-Dichloracetophenon, 1-Hydroxyacetophenon, 2,2-Diethoxyacetophenon, 2-Methyl-1-[4-(methylthio)-phenyl]-2-morpholinopropan-1-on, 2,2-Dimethoxy-1,2-diphenylethan-2-on oder 2-Benzyl-2-dimethylamino-1-(4-morpholinophenyl)-butan-1-on, Benzoine und Benzoinether sind beispielsweise 4-Morpholinodeoxybenzoin, Benzoin, Benzoin-isobutylether, Benzoin-tetrahydropyranylether, Benzoin-methylether, Benzoinethylether, Benzoin-butylether, Benzoin-isopropylether oder 7-H-Benzoin-methylether oder

Ketale sind beispielsweise Acetophenondimethylketal, 2,2-Diethoxyacetophenon, oder Benzilketale, wie Benzildimethylketal.

Phenylglyoxylsäuren sind beispielsweise in DE-A 198 26 712, DE-A 199 13 353 oder WO 98/33761 beschrieben.

Weiterhin verwendbare Photoinitiatoren sind beispielsweise Benzaldehyd, Methylethylketon, 1-Naphthaldehyd, Triphenylphosphin, Tri-o-Tolylphosphin oder 2,3-Butandion.

Typische Gemische umfassen beispielsweise 2-Hydroxy-2-methyl-1-phenyl-propan-2-on und 1-Hydroxy-cyclohexyl-phenylketon, Bis(2,6-dimethoxybenzoyl)-2,4,4-trimethylpentylphosphinoxid und 2-Hydroxy-2-methyl-1-phenyl-propan-1-on, Benzophenon und 1-Hydroxy-cyclohexyl-phenylketon, Bis(2,6-dimethoxybenzoyl)-2,4,4-trimethylpentylphosphinoxid und 1-Hydroxy-cyclohexyl-phenylketon, 2,4,6-Trimethylbenzoyldiphenylphosphinoxid und 2-Hydroxy-2-methyl-1-phenyl-propan-1-on, 2,4,6-Trimethylbenzophenon und 4-Methylbenzophenon oder 2,4,6-Trimethylbenzophenon und 4-Methylbenzophenon und 2,4,6-Trimethylbenzoyldiphenylphosphinoxid.

In einer bevorzugten Ausführungsform der vorliegenden Erfindung ist in den erfindungsgemäßen Beschichtungsmassen mindestens ein UV-Photoinitiator anwesend.

Farbmittel (G) wird im Sinne dieser Schrift zusammenfassend gebraucht für Pigmente und Farbstoffe, bevorzugt für Pigmente.

Pigmente (G) sind gemäß CD Römpp Chemie Lexikon - Version 1.0, Stuttgart/New York: Georg Thieme Verlag 1995 unter Verweis auf DIN 55943 partikelförmige "im Anwendungsmedium praktisch unlösliche, anorganische oder organische, bunte oder unbunte Farbmittel".

Praktisch unlöslich bedeutet dabei eine Löslichkeit bei 25 °C unter 1 g / 1000 g Anwendungsmedium, bevorzugt unter 0,5, besonders bevorzugt unter 0,25, ganz besonders bevorzugt unter 0,1 und insbesondere unter 0,05 g / 1000 g Anwendungsmedium.

Beispiele für Pigmente im eigentlichen Sinne umfassen beliebige Systeme von Absorptions- und/oder Effektpigmenten, bevorzugt Absorptionspigmente. Anzahl und Auswahl der Pigmentkomponenten sind dabei keinerlei Beschränkungen unterworfen. Sie können den jeweiligen Erfordernissen, beispielsweise dem gewünschten Farbeindruck, beliebig angepasst werden. Beispielsweise können alle Pigmentkomponenten eines standardisierten Mischlacksystems zugrunde liegen.

Unter Effektpigmenten sind alle Pigmente zu verstehen, die einen plättchenförmigen Aufbau zeigen und einer Oberflächenbeschichtung spezielle dekorative Farbeffekte verleihen. Bei den Effektpigmenten handelt es sich beispielsweise um alle in der Fahrzeug- und Industrielackierung üblicherweise einsetzbaren effektgebenden Pigmente. Beispiele für derartige Effektpigmente sind reine Metallpigmente; wie z.B. Aluminium-, Eisen- oder Kupferpigmente; Interferenzpigmente, wie z.B. titandioxidbeschichteter Glimmer, eisenoxidbeschichteter Glimmer, mischoxidbeschichteter Glimmer (z.B. mit Titandioxid und Fe₂O₃ oder Titandioxid und Cr₂O₃), metalloxidbeschichtetes Aluminium, oder Flüssigkristallpigmente.

Bei den farbgebenden Absorptionspigmenten handelt es sich beispielsweise um übliche in der Lackindustrie einsetzbare organische oder anorganische Absorptionspigmente. Beispiele für organische Absorptionspigmente sind Azopigmente, Phthalocyanin-, Chinacridon- und Pyrrolopyrrolpigmente. Beispiele für anorganische Absorptionspigmente sind Eisenoxidpigmente, Titandioxid und Ruß.

Farbstoffe sind ebenfalls Farbmittel und unterscheiden sich von den Pigmenten durch ihre Löslichkeit im Anwendungsmedium, d.h. sie weisen bei 25 °C eine Löslichkeit über 1 g / 1000 g im Anwendungsmedium auf.

Beispiele für Farbstoffe sind Azo-, Azin-, Anthrachinon-, Acridin-, Cyanin-, Oxazin-, Polymethin-, Thiazin-, Triarylmethan-Farbstoffe. Diese Farbstoffe können Anwendung finden als basische oder kationische Farbstoffe, Beizen-, Direkt-, Dispersions-, Entwicklungs-, Küpen-, Metallkomplex-, Reaktiv-, Säure-, Schwefel-, Kupplungs- oder Substantive Farbstoffe.

Als weitere lacktypische Additive (H) können beispielsweise Antioxidantien, Stabilisatoren, Aktivatoren (Beschleuniger), Füllmittel, antistatische Agentien, Flammschutzmittel, Verdicker, thixotrope Agentien, oberflächenaktive Agentien, Viskositätsmodifikatoren, Plastifizierer oder Chelatbildner verwendet werden.

Als Beschleuniger für die thermische Nachhärtung kann z.B. Zinnoktoat, Zinkoktoat, Dibutylzinnlaureat oder Diaza[2.2.2]bicyclooctan verwendet werden.

Weiterhin können ein oder mehrere photochemisch und/oder thermisch aktivierbare Initiatoren zugesetzt werden, z.B. Kaliumperoxodisulfat, Dibenzoylperoxid, Cyclohexanonperoxid, Di-tert.-Butylperoxid, Azobis-iso-butyronitril, Cyclohexylsulfonylacetylperoxid, Di-iso-propylpercarbonat, tert-Butylperoktoat oder Benzpinakol, sowie beispielsweise solche thermisch aktivierbare Initiatoren, die eine Halbwertszeit bei 80°C von mehr als 100 Stunden aufweisen, wie Di-t-Butylperoxid, Cumolhydroperoxid, Dicumylperoxid, t-Butylperbenzoat, silylierte Pinakole, die z. B. unter dem Handelsnamen AD-DID 600 der Firma Wacker kommerziell erhältlich sind oder Hydroxylgruppen-haltige Amin-N-Oxide, wie 2,2,6,6-Tetramethylpiperidin-N-oxyl, 4-Hydroxy-2-,2,6,6-Tetramethylpiperidin-N-oxyl etc.

Weitere Beispiele geeigneter Initiatoren sind in "Polymer Handbook", 2. Aufl., Wiley & Sons, New York beschrieben.

Als Verdicker kommen neben radikalisch (co)polymerisierten (Co)Polymerisaten, übliche organische und anorganische Verdicker wie Hydroxymethylcellulose oder Bentonit in Betracht.

Als Chelatbildner können z.B. Ethylendiaminessigsäure und deren Salze sowie β-Diketone verwendet werden.

Als koloristisch inerte Füllstoffe sind alle Stoffe/Verbindungen zu verstehen, die einerseits koloristisch unwirksam sind; d.h. die eine geringe Eigenabsorption zeigen und deren Brechzahl ähnlich der Brechzahl des Beschichtungsmediums ist, und die andererseits in der Lage sind, die Orientierung (parallele Ausrichtung) der Effektpigmente in der Oberflächenbeschichtung, d.h. im applizierten Lackfilm, zu beeinflussen, ferner Eigenschaften der Beschichtung oder der Beschichtungsmassen, beispielsweise Härte oder Rheologie. Im folgenden sind beispielhaft einsetzbare inerte Stoffe/Verbindungen genannt, ohne jedoch den Begriff koloristisch inerte topologiebeeinflussende Füllstoffe auf diese Beispiele zu beschränken. Geeignete inerte Füllstoffe entsprechend der Definition können beispielsweise transparente oder semitransparente Füllstoffe oder Pigmente sein, wie z.B. Kunststoffgranulat, Kieselgele, Blancfixe, Kieselgur, Talkum, Calciumcarbonate, Kalk, Kaolin, Bariumsulfat, Magnesiumsilikat, Aluminiumsilikat, kristallines Siliziumdioxid, amorphe Kieselsäure oder Aluminiumoxid.. Weiterhin können als inerte Füllstoffe beliebige feste inerte organische Partikel, wie z.B. Harnstoff-Formaldehyd-Kondensationsprodukte, mikronisiertes Polyolefinwachs und mikronisiertes Amidwachs, eingesetzt werden. Die inerten Füllstoffe können jeweils auch in Mischung eingesetzt werden. Bevorzugt wird jedoch jeweils nur ein Füllstoff eingesetzt.

Geeignete Stabilisatoren umfassen typische UV-Absorber wie Oxanilide, Triazine und Benzotriazol und Benzophenone. Diese können allein oder zusammen mit geeigneten Radikalfängern, beispielsweise sterisch gehinderten Aminen wie 2,2,6,6-Tetramethylpiperidin, 2,6-Di-tert.-butylpiperidin oder deren Derivaten, z. B. Bis-(2,2,6,6-tetramethyl-4-piperidyl)sebacinat, eingesetzt werden. Stabilisatoren werden üblicherweise in Mengen von 0,1 bis 5,0 Gew.-%, bezogen auf die in der Zubereitung enthaltenen festen Komponenten, eingesetzt.

Die Mischungen der vorliegenden Erfindung sind als IR-aktivierbare Photoinitiatoren verwendbar und zeigen eine bessere Löslichkeit in Beschichtungsmassen und Lacksystemen als die aus dem Stand der Technik bekannten Formulierungen von IR-Photoinitiatoren, bei denen Borationen der Formel (IV) als Gegenion für das Cyanin-Kation fungieren. Dies hat zur Folge, dass einerseits der Photoinitiator gleichmäßiger im Lacksystem verteilt werden kann und im späteren Lack keine ungelösten Partikel als Fehlstellen verbleiben und andererseits eine höhere Photoreaktivität resultiert. Bei den aus dem Stand der Technik bekannten IR-Photoinitiatoren fallen die Verbindungen teilweise aufgrund der mangelnden Löslichkeit als Kristalle in der Beschichtungsmasse aus.

Zum Erzielen dieser besseren Löslichkeit werden die erfindungsgemäßen Mischungen mit strahlungshärtbaren Verbindungen, also beispielsweise Bindemittel (D) und/oder Reaktivverdünner (E) oder solche enthaltende Zubereitungen, wie beispielsweise Beschichtungsmassen, Lacke oder Lackformulierungen, vermischt.

Es ist ein besonderer Vorteil der IR-Photoinitiatoren, dass derartige Photoinitiatoren auch in pigmentierten Lacken eine radikalische Polymerisation initiieren können, da die aktivierende Strahlung in der Regel nicht oder nur geringfügig von Pigmenten absorbiert wird, wohingegen die zur Aktivierung von UV-Photoinitiatoren erforderliche UV-Strahlung üblicherweise von den Pigmenten absorbiert und/oder gestreut wird und deshalb eine geringe Eindringtiefe in die Beschichtung aufweist. Somit stellt es eine bevorzugte Ausführungsform der vorliegenden Erfindung dar, die erfindungsgemäßen Mischungen in pigmentierten Beschichtungsmassen einzusetzen.

Eine weitere vorteilhafte Ausführungsform der vorliegenden Erfindung besteht darin, die erfindungsgemäßen Mischungen in Beschichtungsmassen mit hohen Schichtdicken einzusetzen. So stellt es eine bevorzugte Ausführungsform dar, die Mischungen in Beschichtungsmassen einzusetzen, die eine Schichtdicke von mehr als 30 µm, bevorzugt mehr als 45 und besonders bevorzugt mehr als 60 µm aufweisen. Die Beschichtungsmassen können eine Dicke von bis zu 300, bevorzugt bis zu 250 und besonders bevorzugt bis zu 200 µm aufweisen.

Selbstverständlich können die Beschichtungen auch dicker oder dünner aufgetragen werden, beispielsweise von 10 bis 1000 µm. Bei sehr dick aufgetragenen Beschichtungsmassen kann es jedoch erforderlich sein, mehrmals zu bestrahlen.

Die strahlungshärtbare Beschichtungsmasse kann bevorzugt in einfacher Weise z.B. durch Spritzen, Spachteln, Streichen, Rakeln, Bürsten, Rollen, Walzen, Gießen, Tauchen, Laminieren, Hinterspritzen oder Coextrudieren etc. auf den zu beschichtenden Gegenstand aufgetragen werden und gegebenenfalls getrocknet werden.

Zur Härtung erfolgt eine Bestrahlung mit elektromagnetischer Strahlung, die den sichtbaren und IR-Bereich umfaßt, bevorzugt den Bereich sichtbaren Lichts und besonders bevorzugt mit elektromagnetischer Strahlung im Wellenlängenbereich von 400 - 650 nm.

Die Bestrahlung kann in einer bevorzugten Ausführungsform der Erfindung auch unter Ausschluss von Sauerstoff durchgeführt werden. Dazu wird die Bestrahlung so durchgeführt, dass die Beschichtungsmasse im Moment ihrer Bestrahlung mit IR-Strahlung einem Sauerstoffpartialdruck von weniger als 18 kPa ausgesetzt ist. Die relevanten Bereiche sind die mit den strahlungshärtbaren Beschichtungsmassen versehenen Oberflächenbereichen des zu beschichtenden Gegenstands im Moment der Belichtung. Bevorzugt beträgt der Sauerstoffpartialdruck nicht mehr als 17 kPa, besonders bevorzugt nicht mehr als 15,3 kPa, ganz besonders bevorzugt nicht mehr als 13,5 kPa, insbesondere nicht mehr als 10 kPa und speziell nicht mehr als 6,3 kPa.

Oft ist eine vollständige Sauerstofffreiheit nicht erforderlich, so daß der Sauerstoffpartialdruck bevorzugt 0,5 kPa, besonders bevorzugt 0,9 kPa, ganz besonders bevorzugt 1,8 kPa und insbesondere 2,5 kPa nicht unterschreiten braucht.

Durch die Härtung bei niedrigen Sauerstoffpartialdrücken wird als Vorteil beispielsweise eine verbesserte Kratzfestigkeit beobachtet.

Ein solcher niedriger Sauerstoffpartialdruck kann vorteilhaft durch Verdünnen der sauerstoffhaltigen Atmosphäre mit mindestens einem Inertgas oder Ersatz durch mindestens ein Inertgas, also unter den Strahlungshärtungsbedingungen unreaktiven Gasen, erfolgen. Als Inertgase eignen sich vorzugsweise Stickstoff, Edelgase, Kohlendioxid oder Verbrennungsgase. In der Atmosphäre, unter der die Strahlungshärtung durchgeführt wird, sollte der Anteil des mindestens einen Inertgases mehr als 80 Vol% betragen, bevorzugt mindestens 85, besonders bevorzugt mindestens 90, ganz besonders bevorzugt mindestens 95 und insbesondere mindestens 98 Vol%. Des weiteren kann die Bestrahlung erfolgen, indem die Beschichtungsmasse mit transparenten Medien abgedeckt wird. Transparente Medien sind z. B. Kunststofffolien, Glas oder Flüssigkeiten, z.B. Wasser. Besonders bevorzugt erfolgt die Bestrahlung so, wie beschrieben in der WO 01/14483, auf die hiermit vollständig Bezug genommen wird. Ganz besonders bevorzugt ist eine Bestrahlung in der Weise, wie sie in der DE-A1 199 57 900 beschrieben ist, auf die hiermit vollständig Bezug genommen wird.

Die erfindungsgemäßen Beschichtungsmassen und Lackformulierungen eignen sich besonders zum Beschichten von Substraten wie Holz, bevorzugt Kiefern-, Fichten-, Buchen-, Eichen- oder Ahornholz, Papier, Karton, Pappe, Textil, Leder, Lederersatzstoffe, Vlies, Kunststoffoberflächen, bevorzugt SAN, PMMA, ABS, PP, PS, PC oder PA (Kurzzeichen gemäß DIN 7728), Glas, Keramik, mineralischen Baustoffen, wie Zement-Formsteine und Faserzementplatten, oder Metallen oder beschichteten Metallen, bevorzugt von Kunststoffen oder Metallen, die beispielsweise auch als Folien vorliegen können. Das Metall oder beschichtete Metall kann dabei beispielsweise auch zur Lagerung oder zum Transport zu Rollen, sogenannten "coils" geformt sein. Die Beschichtung der Metalle kann übliche Grundierungsbeschichtungen ("primer") oder eine kathodische Tauchlackierung umfassen.

Besonders bevorzugt eignen sich die erfindungsgemäßen Beschichtungsmassen für Außenbeschichtungen oder in solchen Anwendungen, die dem Tageslicht ausgesetzt sind, bevorzugt von Gebäuden oder Gebäudeteilen, Innenbeschichtungen, Beschichtungen auf Fahrzeugen und Flugzeugen. Insbesondere werden die erfindungsgemäßen Beschichtungsmassen als oder in Automobilklar- und -decklacke(n) eingesetzt sowie in Anstrichmitteln, besonders Fassadenanstrichen, Industrielacken, coil-coatings, Form-, Guß- oder Dentalmassen. Ferner ist es möglich, die erfindungsgemäßen Mischungen zur Aushärtung von Baustoffen, Ziegeln, Klinkern künstlichen Steinen, Estrichen, Putzen und Beschichtungsmassen zu deren Beschichtung einzusetzen. Mit Vorteil sind die erfindungsgemäßen Beschichtungsmassen zur Dekorationslackierung zu verwenden, besonders zur Möbel-, Parkett-, Laminat- und Fußbodenbelaglackierung.

Weiterhin ist es möglich, die erfindungsgemäßen Beschichtungsmassen in Druckverfahren oder zur Herstellung von Druckplatten zu verwenden, beispielsweise in der Stereolithographie, Photolithographie, im Siebdruck, Offset, Flachdruck, Tiefdruck- oder Hochdruckverfahren. sowie im Tintenstrahlverfahren (Ink-Jet).

Die folgenden Beispiele sollen die Eigenschaften der Erfindung erläutern, ohne sie aber einzuschränken.

Als "Teile" oder "%" seien in dieser Schrift, wenn nicht anders angegeben, "Gewichtsteile" oder "Gewicht %" verstanden.

### Beispiel 1: 2-((E)-2-{4-[Bis-(2-cyanoethyl)-amino]-phenyl}-vinyl)-1,3,3-trimethyl-3H-indolium-4-dodecylbenzolsulfonat (Tabelle Nr. 20):

Die Synthese wurde in einer Labvision® Laborautomation durchgeführt, die im Wesentlichen aus zwei Doppelmantelgefäßen, 250 mL und 2500 mL verbunden durch eine Glasbrücke, bestand. Beide Gefäße waren mit Impellerglasrührern, Stromstörern und Thermostaten ausgerüstet. Die Drehzahl im 250 mL- Gefäß betrug 350 U/min und im 2500 mL-Gefäß 250 U/min.

Als erstes wurden 100 g Dimethylformamid (DMF) im 250 mL-Gefäß vorgelegt, 100 g N,N-Bis(cyanoethyl)anilin zugegeben und mit 25,5 g DMF nachgespült. Nun wurde der Thermostat auf 20 °C eingestellt und 80 g Phosphoroxychlorid (POCl₃) innerhalb 40 min zudosiert. Nach Dosierende wurde auf 90 °C erhitzt und 1 h nachgerührt. Während des Hochheizens im kleinen Gefäß wurde im großen Gefäß 300 g Wasser vorgelegt und der Thermostat auf 40 °C eingestellt. Nachdem voller Umsatz im kleinen Gefäß erfolgt ist, wurde die Hydrolyse durchgeführt, d. h. der Bodenablauf im kleinen Gefäß wurde langsam geöffnet und die 90 °C-heiße Reaktionslösung lief durch die Glasbrücke in das mit Wasser gefüllte große Gefäß. Nach ca. 5 Minuten fiel ein feiner hellgelber Feststoff aus. Das kleine Gefäß wurde mit 10-15 mL DMF nachgespült und 5 min nachgerührt. Nun wurden 400 g Diethylketon (DEK) im großen Gefäß zudosiert und nach Zulaufende wurde auf 70°C aufgeheizt. Bei 70°C wurde mit 50%ige Natronlauge innerhalb von 15 min ein pH von 6,0 eingestellt. Danach wurde bei 70 °C 1 h nachgerührt und anschließend fand eine Phasentrennung statt. Die Wasserphase wurde verworfen. Die organische, 70 °C warme Phase wurde bei 200 U/min schnell mit 88 g 1,3,3-Trimethyl-2-methylenindolin (Tribase) und anschließend innerhalb von 6 min mit 52 g konzentrierter Schwefelsäure versetzt. Nun wurde auf 100 °C aufgeheizt und Reaktionswasser abdestilliert. Es wurde etwa 1 h bei 100 °C nachgerührt währenddessen immer noch Reaktionswasser abdestilliert wurde. Danach wurde das Reaktionsgemisch auf 90 °C abgekühlt und eine Lösung aus 184 g Dodecylbenzolsulfonsäure Natriumsalz in 800 g Wasser (Temperatur der Lösung von ca. 60 °C) zugesetzt. Es wurde bei 70 °C 1,75 h nachgerührt. Es erfolgte eine weitere Phasentrennung und die organische Phase wurde im Vakuum eingeengt.
Man erhielt 330 g (92% Ausbeute über 3 Stufen) eines roten Feststoffs.

### Beispiel 2: 2-((E)-2-{4-[(2-Cyanoethyl)-(2-hydroxyethyl)-amino]-2-methyl-phenyl}-vinyl)-1-ethyl-3,3-dimethyl-3H-indolium-4-dodecylbenzolsulfonat (Tabelle Nr. 10)

### Vielsmeier-Haack-Formylierung:

In einem 250 mL Vierhalskolben mit Stickstoffspülung, Rückflußkühler und KPG-Rührer wurden 8 g Dimethylformamid und 8,6 g 2-[(2-Cyanoethyl)-m-tolyl-amino]-ethylessigsäureester vorgelegt. Bei 5° bis 10° C wurden 6 g Phosphoroxychlorid in 10 Minuten zugetropft. Danach wurde auf Raumtemperatur erwärmt, 5,5 Stunden bei 70 °C gerührt und man ließ über Nacht unter Rühren abkühlen. Danach wurden 200 ml Methyl-tert-butylether zugesetzt, mit einem Eiswasserbad abgekühlt, und über 5 Minuten bis max. 10 °C eine Lösung aus 17 g Natriumacetat und 70 mL Wasser zugetropft. Nun erfolgte bei Raumtemperatur Phasentrennung. Die organische Phase wurde mit Wasser und danach mit gesättigter Natriumhydrogencarbonatlösung gewaschen, über Natriumsulfat getrocknet und am Rotationsverdampfer eingeengt.

Es wurden 8,7 g (91% Ausbeute) 2-[(2-Cyanoethyl)-(4-formyl-3-methylphenyl)-amino]-ethylessigsäureester erhalten.

### Acetat-Entschützung:

In einem 500 mL Erlenmeyerkolben mit Rührfisch wurden 120 mL Methanol und 8,7 g 2-[(2-Cyanoethyl)-(4-formyl-3-methylphenyl)-amino]-ethylessigsäureester vorgelegt. Dazu wurden 40 mL Wasser und 3,4 g Natriumcarbonat zugesetzt und über Nacht bei Raumtemperatur gerührt. Am nächsten Morgen wurde abfiltriert und die Mutterlauge auf pH 7 eingestellt. Mittels Rotationsverdampfer wurde Methanol aus dieser Lösung entfernt, mit Dichlormethan drei Mal extrahiert und die vereinigten organischen Phasen über Natriumsulfat getrocknet. Nach Entfernung des organischen Lösungsmittels im Vakuum erhielt man 6,6 g (90% Ausbeute) 3-[(4-Formyl-3-methylphenyl)-(2-hydroxyethyl)-amino]-propionitril.

### Kondensation:

In einem 250 mL Vierhalskolben mit Stickstoffspülung, Rückflußkühler und KPG-Rührer wurden 3,2 g 3-[(4-Formyl-3-methylphenyl)-(2-hydroxyethyl)-amino]-propionitril und 4,2 g 1-Ethyl-2,3,3-trimethylindoliumiodid in 20 mL Toluol und 6 mL n-Butanol suspendiert, auf 105 °C aufgeheizt und 2 h gerührt. Über Nacht wurde auf Raumtemperatur abgekühlt und die erhaltene Suspension abfiltriert. Der Filterkuchen wurde mit Toluol und Methyl-tert-butylether gewaschen und im Vakuum bei 50 °C getrocknet.

Es wurden 6,7 g (95% Ausbeute) 2-((E)-2-{4-[(2-Cyanoethyl)-(2-hydroxyethyl)-amino]-2-methylphenyl}-vinyl)-1-ethyl-3,3-dimethyl-3H-indoliumiodid als roter Feststoff erhalten.

### Umsalzung:

In einem 1000 mL Erlenmeyerkolben mit Rührfisch wurden 3 g 2-((E)-2-{4-[(2-Cyanoethyl)-(2-hydroxyethyl)-amino]-2-methylphenyl}-vinyl)-1-ethyl-3,3-dimethyl-3H-indoliumiodid in 300 mL Dichlormethan gelöst, mit 2,1 g Natriumdodecylbenzolsulfonat in 100 mL Wasser versetzt und 3 h bei Raumtemperatur gerührt. Danach erfolgte Phasentrennung und die organische Phase wurde über Natriumsulfat getrocknet, abfiltriert, im Vakuum eingeengt und getrocknet.

Es wurden 4 g (97% Ausbeute) 2-((E)-2-{4-[(2-Cyanoethyl)-(2-hydroxyethyl)-amino]-2-methyl-phenyl}-vinyl)-1-ethyl-3,3-dimethyl-3H-indolium-4-dodecylbenzolsulfonat als roter Feststoff erhalten.

Analog Beispiel 2 wurden folgende Farbstoffe aus den entsprechenden Edukten hergestellt: Nr. 5, 6 und 7 der Tabelle

Analog Beispiel 2 ohne Acetat-Entschützung wurden folgende Farbstoffe aus den entsprechenden Edukten hergestellt: Nr. 2, 3, 8, 9, 11, 12 und 19 der Tabelle.

Analog Kondensation und Umsalzung aus Beispiel 2 wurden folgende Farbstoffe aus den entsprechenden Edukten hergestellt: Nr. 1, 4, 13, 14 und 15 der Tabelle. Ausgehend von (2-((E)-2-{4-[(2-Chloroethyl)-ethylamino]-2-methyl-phenyl}-vinyl)-1,3,3-trimethyl-3H-indoliumchlorid (Astrazon red 6 B, Bezugsquelle ABCR) bzw. (2-((E)-2-{4-[(2-Chloroethyl)-methyl-amino]-phenyl}-vinyl)-1,3,3-trimethyl-3H-indoliumchlorid (Astrazon pink FG, Bezugsquelle ABCR) erhält man mittels Umsalzung analog Beispiel 2 Nr. 17 und 18 der Tabelle.

Die Beurteilung der Photoinitiatoren erfolgte mit Hilfe des folgenden Schnelltest:
Als Prüfmedium für radikalisch polymerisierbare Lackrohstoffe dienten drei unterschiedliche acrylatgruppenhaltige, handelsübliche Lackrohstoffe der BASF SE, Ludwigshafen vom Acrylat-Typ: Laromer® 8863 (Polyetheracrylat auf Basis von ethoxyliertem Trimethylolpropan), Laromer® PO 84 F (aminmodifiziertes Polyetheracrylat auf Basis von alkoxyliertem Trimethylolpropan) und Laromer® 8987 (Urethanacrylat auf Basis von Hexamethylendiisocyanat als Lösung in Hexandioldiacrylat). Die zu prüfenden Photoinitiatoren wurden in diese Prüfmedien jeweils eingewogen und soweit möglich homogen gelöst. Als Standardkonzentrationen wurden 0,5% Sensibilisator-Farbstoff und 1,5% Coinitiator (B) (in der Regel ein Boranat-Salz, insbesondere ein n-Butyl triphenylboranatsalz) verwendet. Die Einarbeitung und die Handhabung der Proben erfolgten weitgehend ohne direkte Lichteinstrahlung.

Der mit Photoinitiator dotierte Lackrohstoff wurde dann als dünne Schicht auf einen Glasträger appliziert: Auf ein Objektträgerglas wurden 1-3 Tropfen des dotierten Lackrohstoffs getropft, daneben zwei Spacerfolien (ca. 50 µm) gelegt und schließlich die Flüssigkeit mit einem weiteren Objektträgerglas abgedeckt; die beiden Gläser wurden mittels zweier Klammern zusammengepresst. Diese "Sandwich-Proben" wurden dann belichtet. Messungen an ausgehärteten Lackschichten ergaben Schichtdicken um ca. 56 µm.

Für die Aushärtung der oben beschriebenen Proben der dotierten Lackrohstoffe erwiesen sich Halogenlampen aufgrund der besonderen spektralen Empfindlichkeit der hier untersuchten Photoinitiatorsysteme als besonders geeignet. Bei den Standarduntersuchungen wurde ein Diaprojektor (Halogenlampe) eingesetzt und die Proben in definiertem Abstand mit definierten Belichtungszeiten belichtet.

Der Erfolg bei der Photohärtung wurde bei allen Proben zuerst qualitativ bewertet: Hierzu wurden die Sandwich-Proben durch Abnehmen des Deckels geöffnet und der Lackfilm gegebenenfalls mittels Reiben mit einem Metallspatel hinsichtlich seiner Härte wie folgt bewertet: "noch flüssig", "gehärtet - aber weich", "hart".

Ebenso wurde der Grad der Restfarbe nach Härtung begutachtet. Dabei hat sich gezeigt, dass bei Einsatz einiger, in Beispiel 1 und 2 beschriebener Farbstoffe, mehr Restfarbe im Lack zurückblieb, wenn das Gegenion des Farbstoffs ein Iodid war als wenn das Gegenion ein mit langkettigem Alkylrest substituiertes Arylsulfonat war. Beispielweise waren die Lacke mit den Farbstoffen Nr. 16 und 19 aus der obigen Tabelle fast farblos nach Härtung. Die entsprechenden Iodide dagegen zeigten noch schwach hellblaue bzw. schwach rote Farbe.

### Beispiel 3

Cyanin-Kationen zeigen mit mit langkettigen Alkylresten substituierten Arylsulfonaten der Formel (II) als Gegenionen eine erhöhte Photoaktivität verglichen mit solchen, die Alkylsulfonat-Anionen, wie sie bekannt sind aus EP 1091247 A2, als Gegenionen aufweisen.

Als Maß dafür wurde die Zeit in Sekunden gemessen, die unter Bestrahlung mit einer mit 50 W Halogenlampe benötigt wird, klebfreie Lacke von Klarlacken mit einer Schichtdicke von 50 µm zu erhalten. Dazu wurden Gemische von Cyanin-Kationen mit Dodecylsulfonat (Vergleich gemäß EP 1091247 A2) bzw. mit Dodecylbenzolsulfonat (erfindungsgemäß) mit handelsüblichen strahlungshärtbaren Lackkomponenten (Laromer® PO84F, Laromer® 8863, Laromer® 8987 der BASF AG, Ludwigshafen) angefertigt und gehärtet.

Die Ergebnisse sind wie folgt:

| Nr. | Struktur | Laromer PO84F | Laromer 8863 | Laromer 8987 |
|---|---|---|---|---|
| Bsp 3 | 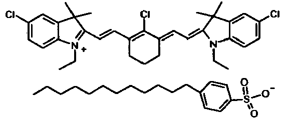 | 1 | 1 | 1 |
| Vglbsp 3 | 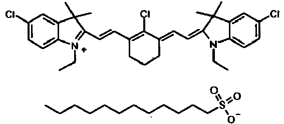 | 60 | 60 | 30 |

| Nr. | Struktur | Laromer PO84F | Laromer 8863 | Laromer 8987 |
|---|---|---|---|---|
| Bsp 4 | 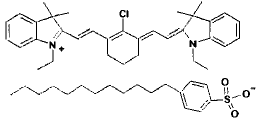 | 32 | 32 | 32 |
| Vglbsp 4 | 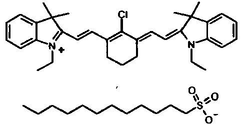 | > 60 | > 60 | > 60 |

Man sieht, daß die Cyanin-Kationen, die mit langkettigen Alkylresten substituierte Arylsulfonate als Gegnionen aufweisen, eine kürzere Zeit bis zur klebfreien Härtung der Filme aufweisen, also eine höhere Photoaktivierbarkeit zeigen, als Dodecylsulfonat.

## Patentansprüche

1. Sensibilisatorsysteme (A) für strahlungshärtbare Beschichtungsmassen aus einem styrylischen Kation D⁺ der Formel (I) 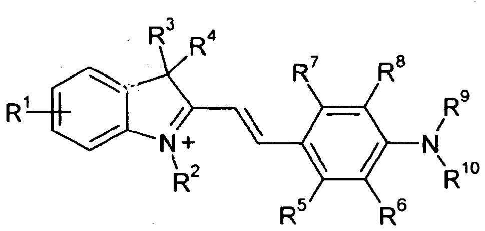 und als Gegenion einem Anion An ausgewählt aus der Gruppe bestehend aus 4-Hexylbenzolsulfonat, 4-Octylbenzolsulfonat, 4-Decylbenzolsulfonat und 4-Dodecylbenzolsulfonat,
worin
R¹, R⁵, R⁶, R⁷ und R⁸, jeweils unabhängig voneinander Wasserstoff, C₁-C₁₈-Alkyl oder C₁-C₁₈-Alkyloxy,
R¹ zusätzlich Halogen, bevorzugt Brom
R², R³ und R⁴ jeweils unabhängig voneinander C₁-C₁₈-Alkyl,
R⁹ und R¹⁰ jeweils unabhängig voneinander gegebenenfalls durch Aryl, Alkyl, Aryloxy, Alkyloxy, Heteroatome und/oder Heterocyclen substituiertes C₁-C₁₈-Alkyl, C₆-C₁₂-Aryl oder C₅-C₁₂-Cycloalkyl,
bedeuten können.

2. Sensibilisatorsysteme gemäß Anspruch 1, **dadurch gekennzeichnet, daß** es sich bei den Resten R⁹ und R¹⁰ jeweils unabhängig voneinander um gegebenenfalls durch Aryl, Alkyl, Aryloxy, Alkyloxy, Heteroatome und/oder Heterocyclen substituiertes C₁-C₁₈-Alkyl handelt.

3. Sensibilisatorsysteme gemäß Anspruch 1, **dadurch gekennzeichnet, daß** die Reste R⁹ und R¹⁰ jeweils unabhängig voneinander ausgewählt sind aus der Gruppe bestehend aus Methyl, Ethyl, n-Propyl, 2-Hydroxyethyl, 2-Hydroxypropyl, 2-Chlorethyl, 2-Cyanethyl, 2-Acetoxyethyl, Cyclohexyl und Cyclopentyl.

4. Sensibilisatorsysteme gemäß Anspruch 1, **dadurch gekennzeichnet, daß** die Reste R¹ bis R¹⁰ die folgende Bedeutung haben:
| Nr. | R¹ | R² | R³ | R⁴ | R⁵ | R⁶ | R⁷ | R⁸ | R⁹ | R¹⁰ |
|---|---|---|---|---|---|---|---|---|---|---|
| 1 | H | Ethyl | Methyl | Methyl | H | H | H | H | R⁹ + R¹⁰: 1,4-Butylen | |
| 2 | H | Ethyl | Methyl | Methyl | H | * | H | * | * | * |
| 3 | H | Ethyl | Methyl | Methyl | H | H | H | H | 2-Chlorethyl | 2-Chlorethyl |
| 4 | H | Ethyl | Methyl | Methyl | H | H | H | H | 2-Hydroxyethyl | Methyl |
| 5 | H | Ethyl | Methyl | Methyl | H | H | H | H | 2-Hydroxyethyl | 2-Hydroxyethyl |
| 6 | H | Ethyl | Methyl | Methyl | H | H | H | H | 2-Hydroxyethyl | Cyclohexyl |
| 7 | H | Ethyl | Methyl | Methyl | H | H | H | H | 2-Hydroxyethyl | 2-Cyanethyl |
| 8 | H | Ethyl | Methyl | Methyl | H | H | H | H | 2-Acetoxyethyl | 2-Acetoxyethyl |
| 9 | H | Ethyl | Methyl | Methyl | H | H | H | H | 2-Cyanethyl | Methyl |
| 10 | H | Ethyl | Methyl | Methyl | Methyl | H | H | H | 2-Hydroxyethyl | 2-Cyanethyl |
| 11 | H | Ethyl | Methyl | Methyl | Methyl | H | H | H | Ethyl | Ethyl |
| 12 | H | Ethyl | Methyl | Methyl | Methyl | H | H | H | Methyl | Methyl |
| 13 | H | Ethyl | Methyl | Methyl | Methyl | H | H | H | R⁹ + R¹⁰: 1,5-Pentylen | |
| 14 | H | Ethyl | Methyl | Methyl | Methyl | H | H | H | R⁹ + R¹⁰: 3-Oxal,5-pentylen | |
| 15 | H | Ethyl | Methyl | Methyl | H | H | H | H | R⁹ + R¹⁰: 3-Oxa1,5-pentylen | |
| 16 | H | Ethyl | Methyl | Methyl | H | H | H | H | Methyl | Methyl |
| 17 | H | Methyl | Methyl | Methyl | H | H | H | H | Methyl | 2-Chlorethyl |
| 18 | H | Methyl | Methyl | Methyl | Methyl | H | H | H | Ethyl | 2-Chlorethyl |
| 19 | H | Ethyl | Methyl | Methyl | H | H | H | H | 2-Cyanethyl | 2-Cyanethyl |
| 20 | H | Methyl | Methyl | Methyl | H | H | H | H | 2-Cyanethyl | 2-Cyanethyl |
| | | | | | | | | | | |
|---|---|---|---|---|---|---|---|---|---|---|
| * Nr.2; R⁹ + R⁸: 1,3-Propylen, R¹⁰ + R⁶: 1,3-Propylen | | | | | | | | | | |

5. Mischungen enthaltend
mindestens eine Komponente (A) der Formel An- Cya⁺, gemäß einem der vorstehenden Ansprüche, und
mindestens eine Komponente (B) mit einem Gegenion ¹/ₓ Kat^{x+}, wobei die Komponente (B) ausgewählt ist aus der Gruppe bestehend aus Tetra-n-octylammonium, Tetramethylammonium, Tetraethylammonium, Tetra-n-butylammonium, Trimethylbenzylammonium, Trimethylcetylammonium, Triethylbenzylammonium, Tri-n-butylbenzylammonium, Trimethylethylammonium, Tri-n-butylethylammonium, Triethylmethylammonium, Tri-n-butylmethylammonium, Di-isopropyl-diethylammonium, Di-isopropyl-ethylmethylammonium, Di-isopropyl-ethyl-benzylammonium, N,N-Dimethylpiperidinium, N,N-Dimethylmorpholinium, N,N-Dimethylpiperazinium oder N-Methyl-diazabicyclo[2,2,2]octan.

6. Mischungen gemäß Anspruch 5, **dadurch gekennzeichnet, daß** das Kation Kat^{x+} ausgewählt ist aus der Gruppe bestehend aus 1-Methylimidazolium, 1-Butylimidazolium, 1,3-Dimethylimidazolium, 1,2,3-Trimethylimidazolium, 1-n-Butyl-3-methylimidazolium, 1-Ethyl-3-methylimidazolium, 1,3,4,5-Tetramethylimidazolium, 1,3,4-Trimethylimidazolium, 2,3-Dimethylimidazolium, 1-Butyl-2,3-dimethylimidazolium, 3,4-Dimethylimidazolium, 2-Ethyl-3,4-dimethylimidazolium, 3-Methyl-2-ethylimidazol, 3-Butyl-1-methylimidazolium, 3-Ethyl-1-methylimidazolium, 3-Butyl-1-ethylimidazolium, 3-Butyl-1,2-dimethylimidazolium, 1,3-Di-n-Butylimidazolium, 3-Butyl-1,4,5-Trimethylimidazolium, 3-Butyl-1,4-Dimethylimidazolium, 3-Butyl-2-methylimidazolium, 1,3-Dibutyl-2-methylimidazolium, 3-Butyl-4-methylimidazolium, 3-Butyl-2-ethyl-4-methylimidazolium, 3-Butyl-2-ethylimidazolium, 1-Methyl-3-Octylimidazolium und 1-Decyl-3-Methylimidazolium.

7. Mischungen gemäß Anspruch 5 oder 6, **dadurch gekennzeichnet, daß** das Gewichtsverhältnis zwischen Komponente (A) der Formel An⁻ Cya⁺ und Komponente (B) mit Gegenion ¹/ₓ Kat^{x+} 1 : 1 bis 1 : 5 beträgt.

8. Strahlungshärtbare Beschichtungsmasse, enthaltend
- mindestens eine Komponente (A) der Formel An⁻ Cya⁺, gemäß einem der Ansprüche 1 bis 4,
- mindestens eine Komponente (B) mit einem Gegenion ¹/ₓ Kat^{x+}, gemäß einem der Ansprüche 5 bis 7,
- gegebenenfalls mindestens ein Lösungsmittel (C),
- mindestens ein Bindemittel (D),
- gegebenenfalls mindestens einen Reaktiwerdünner (E),
- gegebenenfalls mindestens einen UV-Photoinitiator (F),
- gegebenenfalls mindestens ein Farbmittel (G) und
- gegebenenfalls weitere lacktypische Additive (H).

9. Verfahren zur Beschichtung von Substraten, **dadurch gekennzeichnet, daß** man eine strahlungshärtbare Beschichtungsmasse gemäß Anspruch 8 in einer Dicke von 10 bis 1000 µm auf auf den zu beschichtenden Gegenstand aufträgt, gegebenenfalls trocknet und anschließend durch Bestrahlung mit elektromagnetischer Strahlung im Wellenlängenbereich von 400 - 650 nm bestrahlt.

10. Verwendung von strahlungshärtbaren Beschichtungsmasse gemäß Anspruch 8 zum Beschichten von Holz, Papier, Karton, Pappe, Textil, Leder, Lederersatzstoffe, Vlies, Kunststoffoberflächen, Glas, Keramik, mineralischen Baustoffen, Metallen oder beschichteten Metallen.

11. Verwendung von strahlungshärtbaren Beschichtungsmasse gemäß Anspruch 8 als oder in Automobilklar- und -decklacken, in Anstrichmitteln, Industrielacken, coil-coatings, Form-, Guß- oder Dentalmassen.

## Claims

1. A sensitizer system (A) for a radiation-curable coating material, comprising a styrylic cation D⁺ of the formula (I) 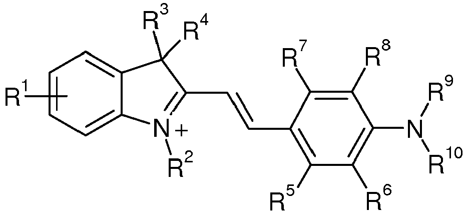 and as counterion an anion An⁻ selected from the group consisting of 4-hexylbenzenesulfonate, 4-octylbenzenesulfonate, 4-decylbenzenesulfonate and 4-dodecylbenzenesulfonate,
in which
R¹, R⁵, R⁶, R⁷ and R⁸ each independently can be hydrogen, C₁-C₁₈ alkyl or C₁-C₁₈ alkyloxy,
R¹ can additionally be halogen, preferably bromine R², R³ and R⁴ each independently can be C₁-C₁₈ alkyl,
R⁹ and R¹⁰ each independently can be unsubstituted or aryl-, alkyl-, aryloxy-, alkyloxy-, heteroatom- and/or heterocycle-substituted C₁-C₁₈ alkyl, C₆-C₁₂ aryl or C₅-C₁₂ cycloalkyl.

2. The sensitizer system according to claim 1, wherein the radicals R⁹ and R¹⁰ are each independently unsubstituted or aryl-, alkyl-, aryloxy-, alkyloxy-, heteroatom- and/or heterocycle-substituted C₁-C₁₈ alkyl.

3. The sensitizer system according to claim 1, wherein the radicals R⁹ and R¹⁰ each independently are selected from the group consisting of methyl, ethyl, n-propyl, 2-hydroxyethyl, 2-hydroxypropyl, 2-chloroethyl, 2-cyanoethyl, 2-acetoxyethyl, cyclohexyl and cyclopentyl.

4. The sensitizer system according to claim 1, wherein the radicals R¹ to R¹⁰ have the following definitions:
| No. | R¹ | R² | R³ | R⁴ | R⁵ | R⁶ | R⁷ | R⁸ | R⁹ | R¹⁰ |
|---|---|---|---|---|---|---|---|---|---|---|
| 1 | H | Ethyl | Methyl | Methyl | H | H | H | H | R⁹ + R¹⁰ : 1, 4-Butylene | |
| 2 | H | Ethyl | Methyl | Methyl | H | * | H | * | * | * |
| 3 | H | Ethyl | Methyl | Methyl | H | H | H | H | 2-Chloroethyl | 2-Chloroethyl |
| 4 | H | Ethyl | Methyl | Methyl | H | H | H | H | 2-Hydroxyethyl | Methyl |
| 5 | H | Ethyl | Methyl | Methyl | H | H | H | H | 2-Hydroxyethyl | 2-Hydroxyethyl |
| 6 | H | Ethyl | Methyl | Methyl | H | H | H | H | 2-Hydroxyethyl | Cyclohexyl |
| 7 | H | Ethyl | Methyl | Methyl | H | H | H | H | 2-Hydroxyethyl | 2-Cyanoethyl |
| 8 | H | Ethyl | Methyl | Methyl | H | H | H | H | 2-Acetoxyethyl | 2-Acetoxyethyl |
| 9 | H | Ethyl | Methyl | Methyl | H | H | H | H | 2-Cyanoethyl | Methyl |
| 10 | H | Ethyl | Methyl | Methyl | Methyl | H | H | H | 2-Hydroxyethyl | 2-Cyanoethyl |
| 11 | H | Ethyl | Methyl | Methyl | Methyl | H | H | H | Ethyl | Ethyl |
| 12 | H | Ethyl | Methyl | Methyl | Methyl | H | H | H | Methyl | Methyl |
| 13 | H | Ethyl | Methyl | Methyl | Methyl | H | H | H | R⁹ + R¹⁰ : 1, 5-Pentylene | |
| 14 | H | Ethyl | Methyl | Methyl | Methyl | H | H | H | R⁹ + R¹⁰: 3-Oxa-1,5-pentylene | |
| 15 | H | Ethyl | Methyl | Methyl | H | H | H | H | R⁹ + R¹⁰: 3-Oxa-1,5-pentylene | |
| 16 | H | Ethyl | Methyl | Methyl | H | H | H | H | Methyl | Methyl |
| 17 | H | Methyl | Methyl | Methyl | H | H | H | H | Methyl | 2-Chloroethyl |
| 18 | H | Methyl | Methyl | Methyl | Methyl | H | H | H | Ethyl | 2-Chloroethyl |
| 19 | H | Ethyl | Methyl | Methyl | H | H | H | H | 2-Cyanoethyl | 2-Cyanoethyl |
| 20 | H | Methyl | Methyl | Methyl | H | H | H | H | 2-Cyanoethyl | 2-Cyanoethyl |
| | | | | | | | | | | |
|---|---|---|---|---|---|---|---|---|---|---|
| * No.2; R⁹ + R⁸: 1,3-propylene, R¹⁰ + R⁶: 1,3-propylene | | | | | | | | | | |

5. A mixture comprising
at least one component (A) of the formula An⁻ Cya⁺, according to any of the preceding claims, and
and at least one component (B) having a counterion ¹/ₓ cat^{x+}, component (B) being selected from the group consisting of tetra-n-octylammonium, tetramethylammonium, tetraethylammonium, tetra-n-butylammonium, trimethylbenzylammonium, trimethylcetylammonium, triethylbenzylammonium, tri-n-butylbenzylammonium, trimethylethylammonium, tri-n-butylethylammonium, triethylmethylammonium, tri-n-butylmethylammonium, diisopropyldiethylammonium, diisopropylethylmethylammonium, diisopropylethylbenzylammonium, N,N-dimethylpiperidinium, N,N-dimethylmorpholinium, N,N-dimethylpiperazinium or N-methyldiazabicyclo[2.2.2]octane.

6. The mixture according to claim 5, wherein the cation cat^{x+} is selected from the group consisting of 1-methylimidazolium, 1-butylimidazolium, 1,3-dimethylimidazolium, 1,2,3-trimethylimidazolium, 1-n-butyl-3-methylimidazolium, 1-ethyl-3-methylimidazolium, 1,3,4,5-tetramethylimidazolium, 1,3,4-trimethylimidazolium, 2,3-dimethylimidazolium, 1-butyl-2,3-dimethylimidazolium, 3,4-dimethylimidazolium, 2-ethyl-3,4-dimethylimidazolium, 3-methyl-2-ethylimidazolium, 3-butyl-1-methylimidazolium, 3-ethyl-1-methylimidazolium, 3-butyl-1-ethylimidazolium, 3-butyl-1,2-dimethylimidazolium, 1,3-di-n-butylimidazolium, 3-butyl-1,4,5-trimethylimidazolium, 3-butyl-1,4-dimethylimidazolium, 3-butyl-2-methylimidazolium, 1,3-dibutyl-2-methylimidazolium, 3-butyl-4-methylimidazolium, 3-butyl-2-ethyl-4-methylimidazolium, 3-butyl-2-ethylimidazolium, 1-methyl-3-octylimidazolium and 1-decyl-3-methylimidazolium.

7. The mixture according to claim 5 or 6, wherein the weight ratio between component (A) of the formula An⁻ Cya⁺ and component (B) with counterion ¹/ₓ cat^{x+} is 1:1 to 1:5.

8. A radiation-curable coating material comprising
- at least one component (A) of the formula An⁻ Cya⁺, according to any of claims 1 to 4,
- at least one component (B) having a counterion ¹/ₓ cat^{x+}, according to any of claims 5 to 7,
- optionally at least one solvent (C),
- at least one binder (D),
- optionally at least one reactive diluent (E),
- optionally at least one UV photoinitiator (F),
- optionally at least one colorant (G) and
- optionally further, typical coatings additives (H).

9. A method of coating a substrate, which comprises applying a radiation-curable coating material according to claim 8 in a thickness of 10 to 1000 µm to the article to be coated, optionally drying, and then irradiating with electromagnetic radiation in the wavelength range of 400 - 650 nm.

10. The use of a radiation-curable coating material according to claim 8 to coat wood, paper, cardboard, paperboard, textile, leather, leather substitutes, nonwovens, plastics surfaces, glass, ceramic, mineral building materials or coated or uncoated metals.

11. The use of a radiation-curable coating material according to claim 8 as or in automotive clearcoat and topcoat materials, in paints, industrial coatings, coil coatings, molding compounds, casting compounds or dental compounds.

## Revendications

1. Systèmes de sensibilisateur (A) pour des masses de revêtement durcissant sous l'effet d'un rayonnement, constitués par un cation de type styryle D⁺ de formule (I) 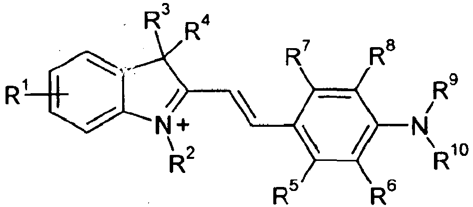 et, comme contre-ion, par un anion An⁻ choisi dans le groupe constitué par le 4-hexylbenzènesulfonate, le 4-octylbenzènesulfonate, le 4-décylbenzènesulfonate et le 4-dodécylbenzènesulfonate,
où
R¹, R⁵, R⁶, R⁷ et R⁸, peuvent représenter, à chaque fois indépendamment les uns des autres, hydrogène, C₁-C₁₈-alkyle ou C₁-C₁₈-alkyloxy,
R¹ peut représenter en outre halogène, de préférence brome
R², R³ et R⁴ peuvent représenter, à chaque fois indépendamment les uns des autres, C₁-C₁₈-alkyle,
R⁹ et R¹⁰ peuvent représenter, à chaque fois indépendamment l'un de l'autre, C₁-C₁₈-alkyle, C₆-C₁₂-aryle ou C₅-C₁₂-cycloalkyle, le cas échéant substitués par aryle, alkyle, aryloxy, alkyloxy, des hétéroatomes et/ou des hétérocycles.

2. Systèmes de sensibilisateur selon la revendication 1, **caractérisés en ce qu'**il s'agit, pour les radicaux R⁹ et R¹⁰, à chaque fois indépendamment l'un de l'autre, de C₁-C₁₈-alkyle le cas échéant substitué par aryle, alkyle, aryloxy, alkyloxy, des hétéroatomes et/ou des hétérocycles.

3. Systèmes de sensibilisateur selon la revendication 1, **caractérisés en ce que** les radicaux R⁹ et R¹⁰ sont choisis, à chaque fois indépendamment l'un de l'autre, dans le groupe constitué par méthyle, éthyle, n-propyle, 2-hydroxyéthyle, 2-hydroxypropyle, 2-chloroéthyle, 2-cyanoéthyle, 2-acétoxyéthyle, cyclohexyle et cyclopentyle.

4. Systèmes de sensibilisateur selon la revendication 1, **caractérisés en ce que** les radicaux R¹ à R¹⁰ présentent la signification suivante :
| Nr. | R¹ | R² | R³ | R⁴ | R⁵ | R⁶ | R⁷ | R⁸ | R⁹ | R¹⁰ |
|---|---|---|---|---|---|---|---|---|---|---|
| 1 | H | éthyle | méthyle | méthyle | H | H | H | H | R⁹ + R¹⁰ : 1, 4-butylène | |
| 2 | H | éthyle | méthyle | méthyle | H | * | H | * | * | * |
| 3 | H | éthyle | méthyle | méthyle | H | H | H | H | 2-chloroéthyle | 2-chloroéthyle |
| 4 | H | éthyle | méthyle | méthyle | H | H | H | H | 2-hydroxyéthyle | méthyle |
| 5 | H | éthyle | méthyle | méthyle | H | H | H | H | 2-hydroxyéthyle | 2-hydroxyéthyle |
| 6 | H | éthyle | méthyle | méthyle | H | H | H | H | 2-hydroxyéthyle | cyclohexyle |
| 7 | H | éthyle | méthyle | méthyle | H | H | H | H | 2-hydroxyéthyle | 2-cyanoéthyle |
| 8 | H | éthyle | méthyle | méthyle | H | H | H | H | 2-acétoxyéthyle | 2-acétoxyéthyle |
| 9 | H | éthyle | méthyle | méthyle | H | H | H | H | 2-cyanoéthyle | méthyle |
| 10 | H | éthyle | méthyle | méthyle | méthyle | H | H | H | 2-hydroxyéthyle | 2-cyanoéthyle |
| 11 | H | éthyle | méthyle | méthyle | méthyle | H | H | H | éthyle | éthyle |
| 12 | H | éthyle | méthyle | méthyle | méthyle | H | H | H | méthyle | méthyle |
| 13 | H | éthyle | méthyle | méthyle | méthyle | H | H | H | R⁹ + R¹⁰ : 1, 5-pentylène | |
| 14 | H | éthyle | méthyle | méthyle | méthyle | H | H | H | R⁹ + R¹⁰ : 3-oxa-1,5-pentylène | |
| 15 | H | éthyle | méthyle | méthyle | H | H | H | H | R⁹ + R¹⁰ : 3-oxa-1,5-pentylène | |
| 16 | H | éthyle | méthyle | méthyle | H | H | H | H | méthyle | méthyle |
| 17 | H | méthyle | méthyle | méthyle | H | H | H | H | méthyle | 2-chloroéthyle |
| 18 | H | méthyle | méthyle | méthyle | méthyle | H | H | H | éthyle | 2-chloroéthyle |
| 19 | H | éthyle | méthyle | méthyle | H | H | H | H | 2-cyanoéthyle | 2-cyanoéthyle |
| 20 | H | méthyle | méthyle | méthyle | H | H | H | H | 2-cyanoéthyle | 2-cyanoéthyle |
| | | | | | | | | | | |
|---|---|---|---|---|---|---|---|---|---|---|
| * N° 2 ; R⁹ + R⁸ : 1,3-propylène, R¹⁰ + R⁶ : 1,3-propylène | | | | | | | | | | |

5. Mélanges contenant
au moins un composant (A) de formule An⁻ Cya⁺, selon l'une quelconque des revendications précédentes, et au moins un composant (B) présentant un contre-ion 1/x Cat^{x+}, le composant (B) étant choisi dans le groupe constitué par le tétra-n-octylammonium, le tétraméthylammonium, le tétraéthylammonium, le tétra-n-butylammonium, le triméthylbenzylammonium, le triméthylcétylammonium, le triéthylbenzylammonium, le tri-n-butylbenzylammonium, le triméthyléthylammonium, le tri-n-butyléthylammonium, le triéthylméthylammonium, le tri-n-butylméthylammonium, le diisopropyldiéthylammonium, le diisopropyléthylméthylammonium, le diisopropyléthylbenzylammonium, le N,N-diméthylpipéridinium, le N,N-diméthylmorpholinium, le N,N-diméthylpipérazinium ou le N-méthyldiazabicyclo[2,2,2]octane.

6. Mélanges selon la revendication 5, **caractérisés en ce que** le cation Cat^{x+} est choisi dans le groupe constitué par le 1-méthylimidazolium, le 1-butylimidazolium, le 1,3-diméthylimidazolium, le 1,2,3-triméthylimidazolium, le 1-n-butyl-3-méthylimidazolium, le 1-éthyl-3-méthylimidazolium, le 1,3,4,5-tétraméthylimidazolium, le 1,3,4-triméthylimidazolium, le 2,3-diméthylimidazolium, le 1-butyl-2,3-diméthylimidazolium, le 3,4-diméthylimidazolium, le 2-éthyl-3,4-diméthylimidazolium, le 3-méthyl-2-éthylimidazole, le 3-butyl-1-méthylimidazolium, le 3-éthyl-1-méthylimidazolium, le 3-butyl-1-éthylimidazolium, le 3-butyl-1,2-diméthylimidazolium, le 1,3-di-n-butylimidazolium, le 3-butyl-1,4,5-triméthylimidazolium, le 3-butyl-1,4-diméthylimidazolium, le 3-butyl-2-méthylimidazolium, le 1,3-dibutyl-2-méthylimidazolium, le 3-butyl-4-méthylimidazolium, le 3-butyl-2-éthyl-4-méthylimidazolium, le 3-butyl-2-éthylimidazolium, le 1-méthyl-3-octylimidazolium et le 1-décyl-3-méthylimidazolium.

7. Mélanges selon la revendication 5 ou 6, **caractérisés en ce que** le rapport pondéral entre le composant (A) de formule An⁻ Cya⁺ et le composant (B) présentant le contre-ion 1/x Cat^{x+} vaut 1:1 à 1:5.

8. Masse de revêtement durcissant sous l'effet d'un rayonnement, contenant
- au moins un composant (A) de formule An⁻ Cya⁺, selon l'une quelconque des revendications 1 à 4,
- au moins un composant (B) présentant un contre-ion 1/x Cat^{x+}, selon l'une quelconque des revendications 5 à 7,
- le cas échéant au moins un solvant (C),
- au moins un liant (D),
- le cas échéant au moins un diluant réactif (E),
- le cas échéant au moins un photo-initiateur UV (F),
- le cas échéant au moins un autre colorant (G) et
- le cas échéant d'autres additifs caractéristiques des laques (H).

9. Procédé pour le revêtement de substrats, **caractérisé en ce qu'**on applique une masse de revêtement durcissant sous l'effet d'un rayonnement selon la revendication 8 en une épaisseur de 10 à 1000 µm sur l'objet à revêtir, on sèche le cas échéant et on irradie ensuite par une irradiation à l'aide d'un rayonnement électromagnétique dans la plage de longueurs d'onde de 400-650 nm.

10. Utilisation de la masse de revêtement durcissant sous l'effet d'un rayonnement selon la revendication 8 pour le revêtement de bois, de papier, de carton, de carton-pâte, de textile, de cuir, de matériaux d'imitation du cuir, de non-tissé, de surfaces en matériau synthétique, de verre, de céramique, de matériaux de construction minéraux, de métaux ou de métaux revêtus.

11. Utilisation de la masse de revêtement durcissable sous l'effet d'un rayonnement selon la revendication 8 comme ou dans des laques claires et de recouvrement pour automobiles, dans des agents d'enduction, des laques industrielles, des revêtements de bobines, des masses de moulage, des masses de coulage ou des masses dentaires.
